# EUROPEAN PATENT SPECIFICATION

(11) **EP 1 385 182 B1**
(45) Date of publication and mention of the grant of the patent: **25.05.2005**
(21) Application number: 03022262.4
(22) Date of filing: 09.08.1999
(51) Int. Cl.: H01G 9/20, H01M 6/16, H01M 10/40

(54) **Pyridinium compounds and their use in a photoelectrochemical cell**
Pyridiniumverbindungen und ihre Verwendung in einer photoelektrochemischen Zelle
Composés pyridinium et leur utilisation dans des cellules photoélectrochimiques

(30) Priority: 11.08.1998 JP 23948298; 11.08.1998 JP 23948398
(43) Date of publication of application: 28.01.2004
(62) Divisional of application: 99115684.5
(73) Proprietor: Fuji Photo Film Co., Ltd., Kanagawa (JP)
(72) Inventor: Takizawa, Hiroo, Fuji Photo Film Co., Ltd., Kanagawa (JP); Shiratsuchi, Kentaro, Fuji Photo Film Co., Ltd., Kanagawa (JP)
(74) Representative: Patentanwälte Dr. Solf & Zapf

(56) References cited:
- EP-A- 0 718 288
- EP-A- 0 720 189
- WO-A-97/02252
- GORDON C M ET AL: "IONIC LIQUID CRYSTALS: HEXAFLUOROPHOSPHATE SALTS" JOURNAL OF MATERIALS CHEMISTRY, THE ROYAL SOCIETY OF CHEMISTRY, CAMBRIDGE, GB, vol. 8, no. 12, December 1998 (1998-12), pages 2627-2636, XP000804817 ISSN: 0959-9428

## Description

### FIELD OF THE INVENTION

This invention relates to a novel compound useful as an electrolyte, an electrolyte containing the same particularly for photo-electrochemical cell, and a photo-electrochemical cell having the electrolyte.

### BACKGROUND OF THE INVENTION

Study of sunlight-power generation converting a light energy into an electric energy has been directed chiefly to development of monocrystalline silicon solar cells, polycrystalline silicon solar cells, amorphous silicon solar cells, and compound solar cells using cadmium telluride, copper indium selenide, etc. It is required for spread of solar cells to overcome such difficulties as a high production cost, a short supply of raw materials, and a long energy payback time. Although many solar cells using organic materials have been proposed aiming at an increase of working area and a reduction of cost, they have a low conversion efficiency and poor durability.

Under these circumstances, Nature, vol. 353, pp. 737-740 (1991) and U.S. Patent 4,927,721 disclosed a photoelectric conversion device using a dye-sensitized oxide semiconductor and a photo-electrochemical cell using the device as a cell. The photoelectric conversion device is composed of an electrically conductive substrate, a photosensitive layer containing a semiconductor having a dye adsorbed on the surface thereof, a charge transporting layer and a counter electrode. The charge transporting layer is made of a redox system serving for charge transport between the negative electrode and the counter electrode, i.e., a positive electrode. The photo-electrochemical cell disclosed in the above U.S. Patent is a wet type solar cell using an aqueous solution containing an electrolyte salt, such as potassium iodide, (i.e., an electrolytic solution) as a charge transporting layer. This system is promising in that the energy conversion efficiency attained is relatively high for the cost. The problem is that, because the charge transporting layer comprises an electrolytic solution containing a low-boiling solvent in a large proportion, such as a potassium iodide aqueous solution, there is a fear that the cell will be short of the electrolytic solution due to evaporation in long-term use only to have a seriously deteriorated photoelectric conversion efficiency or fail to function as a cell.

To solve this problem, WO95/18456 teaches use of an imidazolium salt that is a low-melting compound as an electrolyte so as to prevent a shortage of an electrolytic solution. According to this method, water or an organic solvent that has been used as a solvent for an electrolyte is not used at all or used in a reduced amount so that improvement in durability can result. However, the durability is still insufficient and, besides, an increase in concentration of the imidazolium salt results in a reduction of photoelectric conversion efficiency. Use of a triazolium salt as an electrolyte has also been proposed, which is accompanied by the same problems as with the imidazolium salt.

EP-A-0 718 288 describes a photoelectrochemical cell wherein the charge transporting layer comprises an electrolyte containing a compound with a methyl hexyl imidazolium cation and an iodide anion. WO-A-97 02 252 refers to electrolytes for electrochemical capacitors which may contain compounds with alkyl substituted pyridinium cations, e.g. N-butyl-pyridinium.

### SUMMARY OF THE INVENTION

An object of the invention is to provide an electrolyte excellent in photoelectric (conversion) characteristics and durability, particularly an electrolyte for a photo-electrochemical cell.

Another object of the invention is provide a novel compound which can provide such an electrolyte.

A further object of the invention is to provide a photo-electrochemical cell excellent in photoelectric characteristics and durability.

The above objects are accomplished by:
1) A photo-electrochemical cell comprising a semiconductor responsive to a radiant ray, a charge transporting layer, and a counter electrode, wherein the charge transporting layer comprises an electrolyte containing a compound represented by formula (I'): 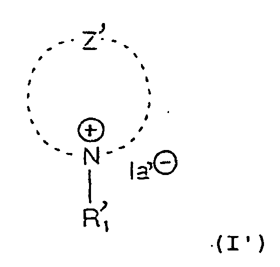 wherein Z' represents an atomic group necessary to form a 6-membered aromatic ring cation together with the nitrogen atom; R₁' represents an alkyl group or an alkenyl group; and a' represents 1 or 3; and
2) A pyridinium compound represented by formula (IV'): 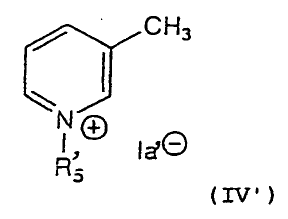 wherein R₅' represents an unsubstituted straight-chain alkyl group having 4 to 8 carbon atoms; and a' represents 1 or 3.

The electrolyte used in the photo-electrochemical cell according to the invention hardly volatilizes and exhibits excellent charge transport performance. The photo-electrochemical cell has excellent photoelectric (conversion) characteristics and hardly undergoes deterioration of performance with time.

### BRIEF DESCRIPTION OF THE DRAWING

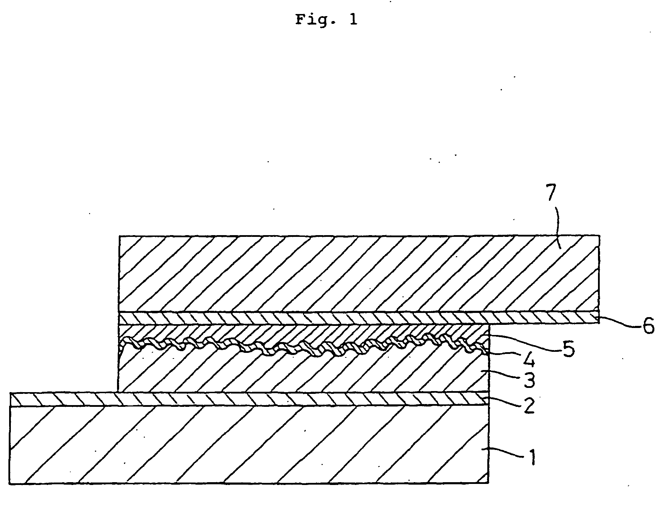

Fig. 1 is a schematic cross section of the photo-electrochemical cell prepared in Examples.

### DETAILED DESCRIPTION OF THE INVENTION

The electrolyte which contains the compound represented by formula (I') (hereinafter referred to as the compound (I')) is useful as a reaction solvent in chemical reactions, chemical plating, etc. and as an electrolyte of various batteries in CCD (charge coupled device) cameras and the like. It is particularly useful in lithium secondary batteries and photo-electrochemical cells having a semiconductor and especially in photo-electrochemical cells.

The compound (I') is so-called molten salts that are liquid at room temperature (25°C) or that are solid at room temperature and have a low melting point. Having an extremely higher boiling point than general low-molecular solvents, the compound (I') has low volatility when used as an electrolyte and is effective in preventing deterioration of cell performance by volatilization. In addition it exhibits sufficient charge transport performance to secure high photoelectric conversion efficiency when used in photo-electrochemical cells. The compound (I') is markedly superior in such performance to the known compounds which similarly avoid the necessity of using a solvent, such as imidazolium salts and triazolium salts.

In formula (I'), Z' represents an atomic group necessary to form a cation of a 6-membered aromatic ring together with the nitrogen. Examples of the atoms that constitute the aromatic ring preferably include carbon, hydrogen, nitrogen, oxygen, and sulfur. Examples of the 6-membered aromatic ring completed by Z' preferably includes pyridine, pyrimidine, pyridazine, pyrazine, and triazine rings, with a pyridine ring being preferred. The 6-membered aromatic ring may have a substituent(s) in addition to R₁', such as an alkyl group, an acyloxy group, a heterocyclic group, a cyano group, an alkoxycarbonyl group, a halogen atom, an alkoxy group, an alkenyl group, and an aryl group.

R₁' represents a substituted or unsubstituted and straight-chain or branched alkyl group, which preferably contains 1 to 24 carbon atoms (e.g., methyl, ethyl, propyl, butyl, isopropyl, pentyl, hexyl, octyl, 2-ethylhexyl, t-octyl, decyl, dodecyl, tetradecyl, 2-hexyldecyl, octadecyl, benzyl, 2-ethoxyethyl, 2-butoxyethyl, heptafluoropropyl, cyanomethyl, methoxycarbonylmethyl, 12-(pyridinium-1-yl)dodecyl) or a substituted or unsubstituted and straight-chain or branched alkenyl group, which preferably contains 2 to 24 carbon atoms (e.g., vinyl or allyl). R₁' preferably represents an alkyl group having 3 to 18 carbon atoms or an alkenyl group having 2 to 18 carbon atoms, still preferably an unsubstituted alkyl group having 4 to 12 carbon atoms, a vinyl group, or an allyl group, particularly preferably an unsubstituted (and preferably straight-chain) alkyl group having 4 to 10 carbon atoms. An unsubstituted straight-chain alkyl group having 4 to 8 carbon atoms is especially preferred as R₁'.

a' represents 1 or 3. When a' is 1, Ia⁻ is I⁻, i.e., a reducing substance in the electrolyte. When a' is 3, Ia⁻ is I₃⁻, i.e., an oxidizing substance.

R₁' or other substituents (or atoms) on the 6-membered aromatic ring completed by Z' can have the same quaternary salt of the nitrogen-containing 6-membered aromatic ring as in the formula (I').

Of the compounds (I') preferred are compounds represented by formula (II') (hereinafter simply referred to as the compound (II')): 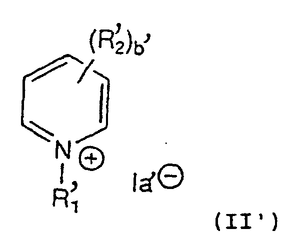 wherein R₁' and a' are as defined above; R₂' represents a substituent; b' represents an integer of 0 to 5; when b' is 2 or greater, (R₂')'s may be the same or different.

The substituent represented by R₂' preferably includes a substituted or unsubstituted and straight-chain or branched alkyl group, which preferably contains 1 to 24 carbon atoms, e.g., methyl, ethyl, isopropyl, butyl, t-butyl, octyl, 2-ethylhexyl, 2-methoxyethyl, benzyl, trifluoromethyl, cyanomethyl, ethoxycarbonylmethyl, propoxyethyl, 3-(1-octylpyridinium-4-yl)propyl, or 3-(1-butyl-3-methylpyridinium-4-yl)propyl; a substituted or unsubstituted and straight-chain or branched alkenyl group, which preferably contains 2 to 24 carbon atoms, e.g., vinyl or allyl; a substituted or unsubstituted aryl group which may be a condensed ring and preferably contains 6 to 24 carbon atoms, e.g., phenyl, 4-methylphenyl, 3-cyanophenyl, 2-chlorophenyl or 2-naphthyl; a substituted or unsubstituted heterocyclic ring which may be a condensed ring and preferably contains 2 to 24 carbon atoms, e.g., 4-pyridyl, 2-pyridyl, 1-octylpyridinium-4-yl, 2-pyrimidyl, 2-imidazolyl or 2-thiazolyl (where it is a nitrogen-containing heterocyclic group, the nitrogen atom in the ring may be quaternized); an alkoxy group, which preferably contains 1 to 24 carbon atoms, e.g., methoxy, ethoxy, butoxy or octyloxy; an acyloxy group, which preferably contains 1 to 24 carbon atoms, e.g., acetyloxy or benzoyloxy; an alkoxycarbonyl group, which preferably contains 2 to 24 carbon atoms, e.g., methoxycarbonyl or ethoxycarbonyl; a cyano group, and a halogen atom, e.g., chlorine or bromine. R₂' is preferably an alkyl group, an alkenyl group, an alkoxy group, an alkoxycarbonyl group, a cyano group or a halogen atom; still preferably an alkyl group, an alkenyl group, an alkoxycarbonyl group or a cyano group; particularly preferably an unsubstituted alkyl group having 1 to 8 carbon atoms, an alkyl group having 1 to 8 carbon atoms which is substituted by a cyano group or an alkoxycarbonyl group, an alkenyl group or an alkoxycarbonyl group having 2 to 20 carbon atoms. Of these substituents, preferred as R₂' are a methyl group, an ethyl group, a cyanomethyl group, an alkoxycarbonylmethyl group, a vinyl group, and an alkoxycarbonyl group; particularly an unsubstituted alkyl group, a cyanoalkyl group, and an alkoxycarbonyl group; especially a methyl group, an ethyl group, a cyanomethyl group, a methoxycarbonyl group, and an ethoxycarbonyl group. A methyl group is the most preferred.

b' is preferably an integer of 0 to 2, still preferably 0 or 1, particularly preferably 1. Where b' is 1, R₂' is preferably at the p- or m-position with respect to the nitrogen of the pyridinium ring, and R₁' is preferably an unsubstituted (and preferably straight-chain) alkyl group having 4 to 8 carbon atoms, particularly a butyl group. In this case, a preferred position of R₂' is the p-position for conversion efficiency and the m-position for durability. Where b' is 0, it is also preferred for a short circuit current that R₁' be an unsubstituted (and preferably straight-chain) alkyl group having 4 to 8 carbon atom, especially a butyl group.

R₁' or R₂' may have the same pyridinium salt as in formula (II').

Of the pyridinium compounds (II') preferred are those represented by formula (III'): 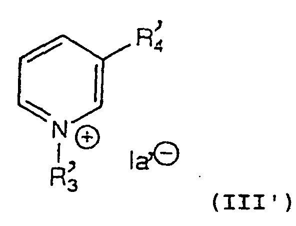 wherein a' is as defined above; R₃' represents an unsubstituted alkyl group having 4 to 10 carbon atoms; and R₄' represents an unsubstituted or cyano-substituted alkyl group or an alkoxycarbonyl group.

In formula (III'), R₃' is preferably an unsubstituted alkyl group having 4 to 8 carbon atoms, still preferably a straight-chain alkyl group, particularly preferably a butyl group, a hexyl group or an octyl group. In particular, a butyl or hexyl group is preferred for efficiency, and an octyl or hexyl group is preferred for durability. R₄' is preferably an unsubstituted or cyano-substituted alkyl group having 1 to 8 carbon atoms, e.g., methyl, ethyl, isopropyl, t-butyl, cyanomethyl or 2-cyanomethyl, or an alkoxycarbonyl group having 2 to 20 carbon atoms, e.g., methoxycarbonyl, ethoxycarbonyl, butoxycarbonyl, 2-ethylhexyloxycarbonyl or hexadecyloxycarbonyl, and still preferably a methyl, ethyl, cyanomethyl or alkoxycarbonyl group. A methyl group is particularly preferred as R₄'.

The compounds (III') are liquid at room temperature, having a lower melting point than the other compounds belonging to (I'). The compounds (III') are more preferred as compared with those of the compounds belonging to (I') and (II') and not belonging to (III'), for achievement of the object of the invention.

Of the compounds (I'), particularly preferred are pyridinium compounds represented by formula (IV'): 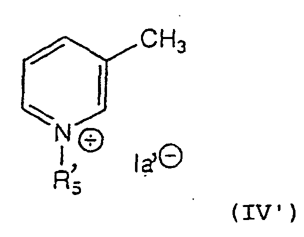 wherein a' is as defined above; R_{5'} represents an unsubstituted straight-chain alkyl group having 4 to 8 carbon atoms.

The compounds of formula (IV') are novel compounds. In formula (IV'), R₅' includes butyl, hexyl and octyl groups.

Specific but non-limiting examples of the compounds (I') are tabulated below by way of cation/anion combinations in formula (I'):

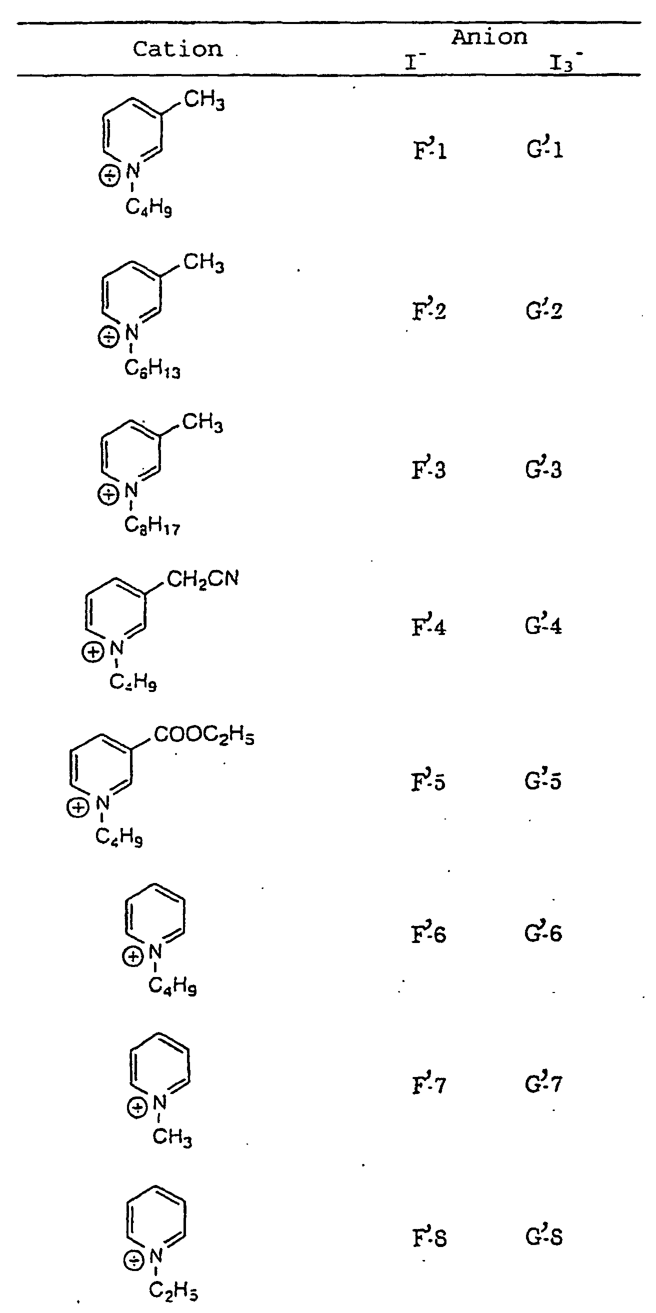

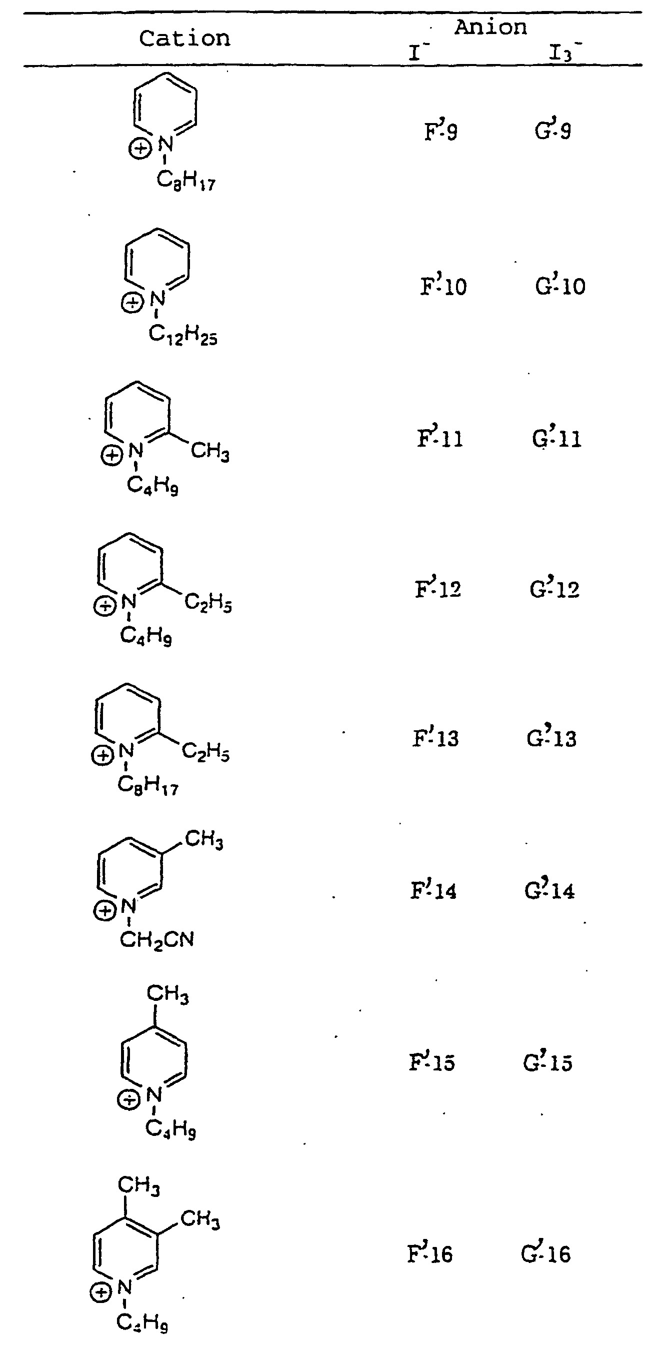

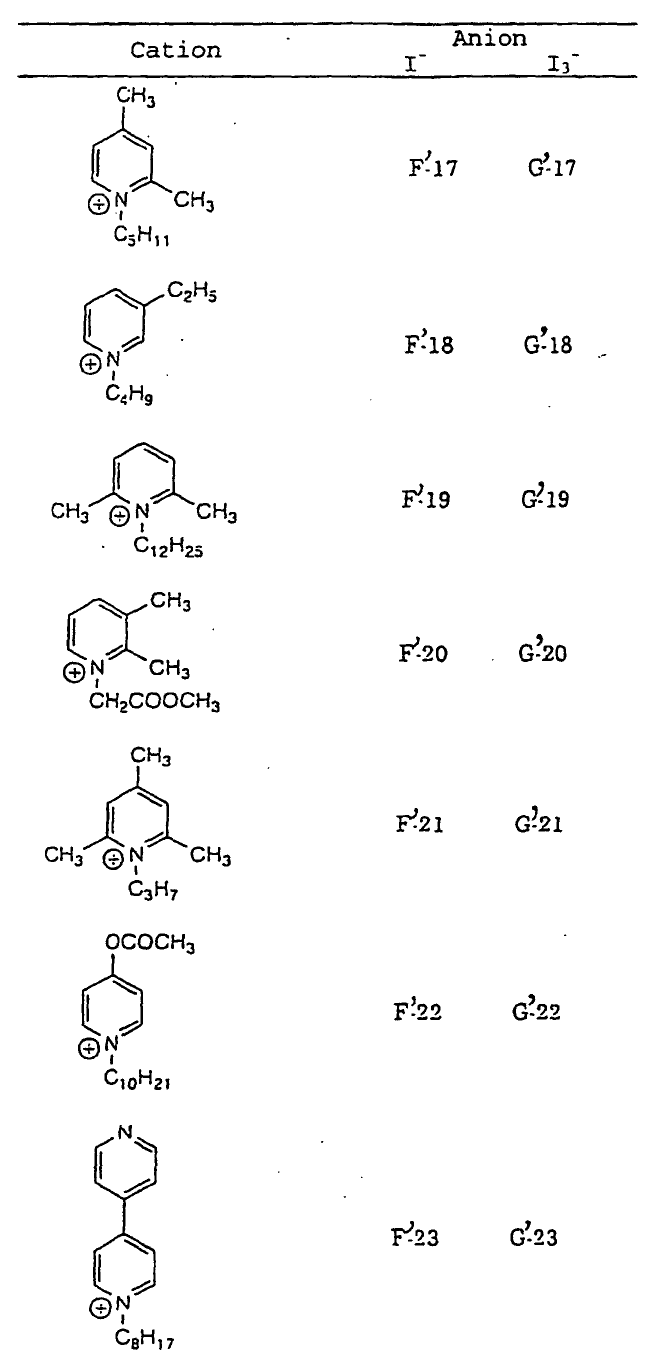

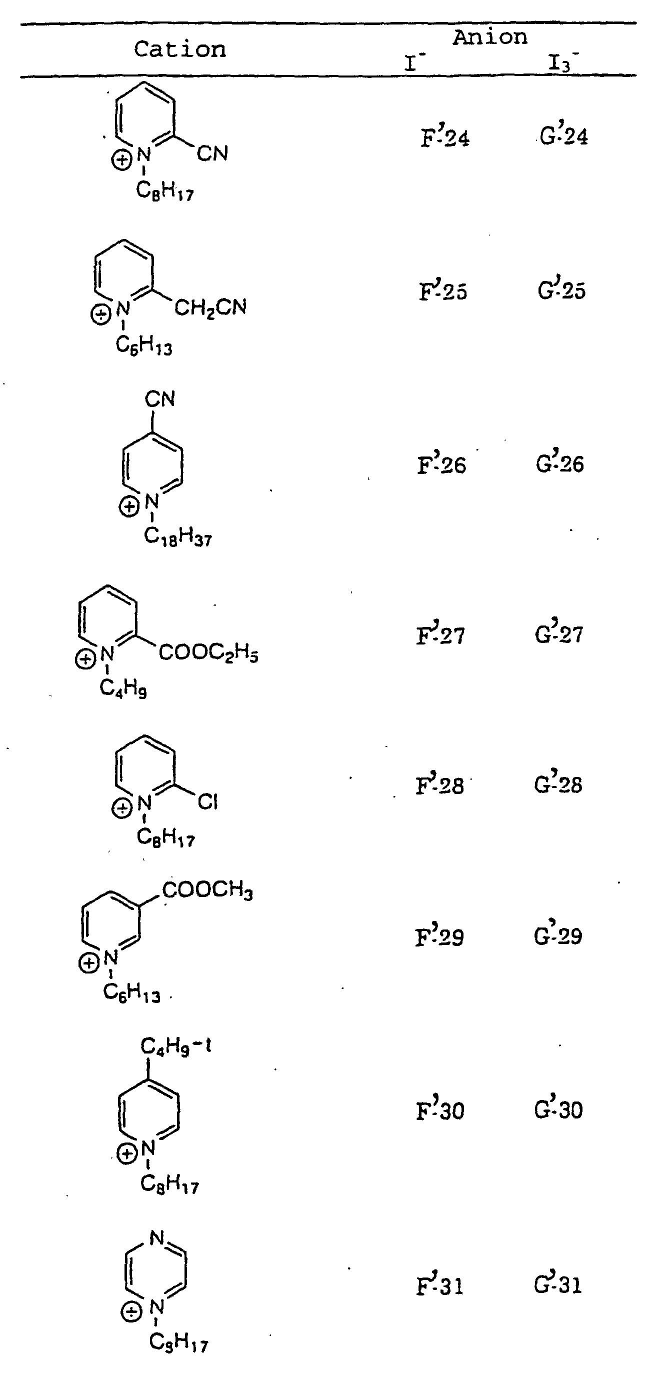

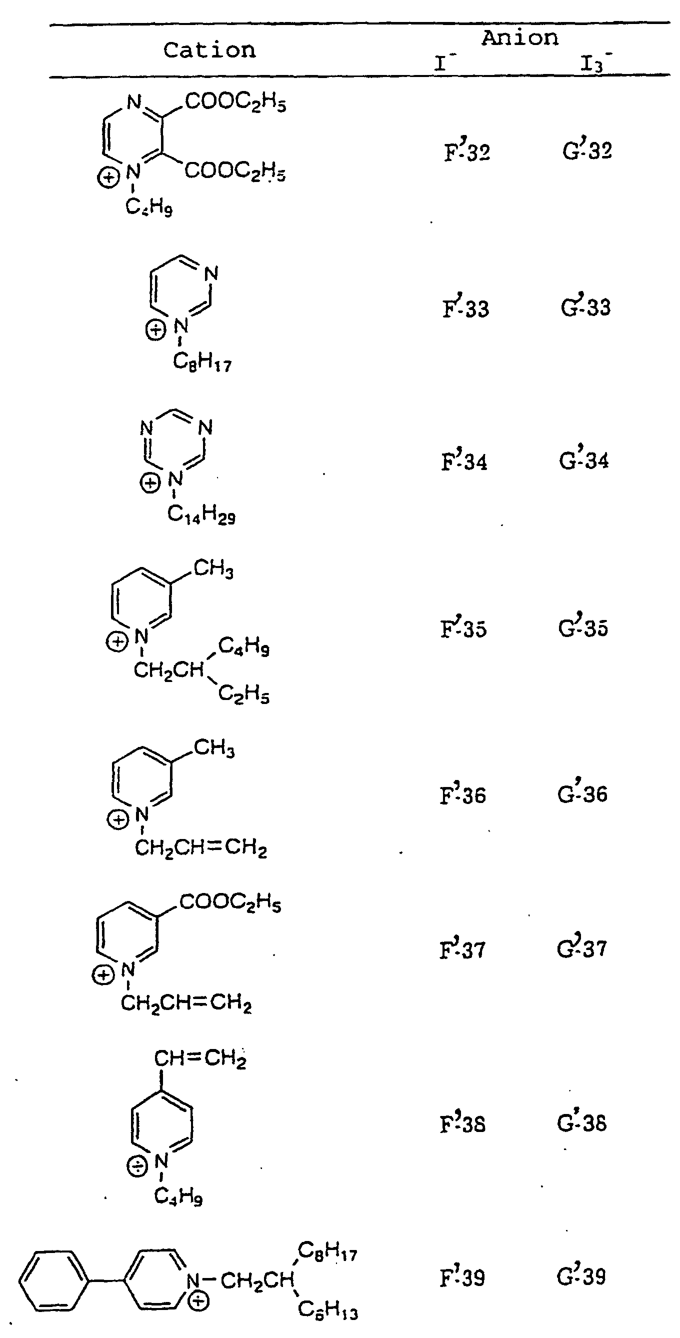

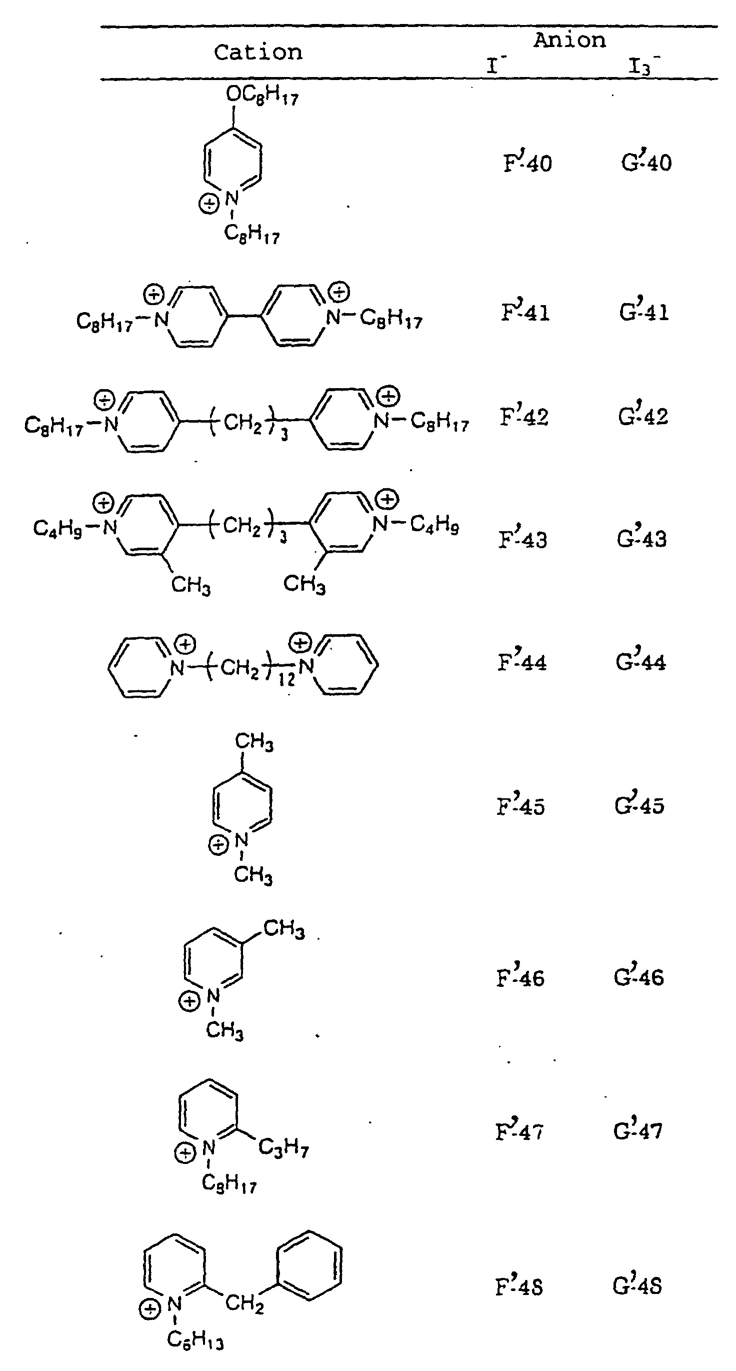

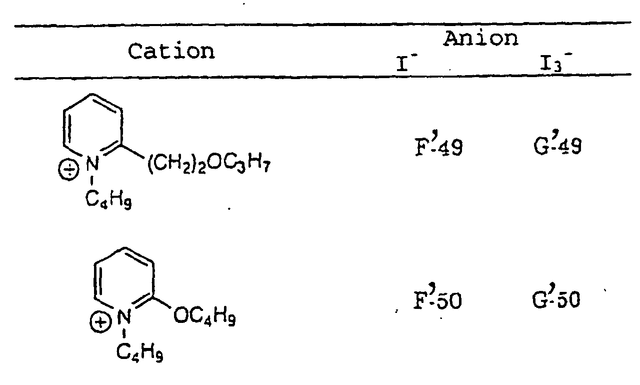

The compounds (I') can be used either individually or as a mixture thereof. It is preferred to use a mixture of compounds (I') having the same cation and different anions at an arbitrary I₃⁻ to I⁻ ratio. The ratio of I₃⁻ to I⁻ is preferably 0.1 to 50 mol%, still preferably 0.1 to 20 mol%, particularly 0.5 to 10 mol%, especially 0.5 to 5 mol%.

Of the compounds (I') those having I⁻ are generally synthesized with ease by reacting an alkyl iodide, an alkenyl iodide, etc. with a nitrogen-containing 6-membered aromatic ring compound, such as a pyridine compound, under heating. Those having I₃⁻ are easily synthesized by adding I₂ to the compound (I') having I⁻. Accordingly, the above-described mixture is conveniently prepared by previously synthesizing a compound having I⁻ and, on use as an electrolyte, adding a predetermined amount of I₂.

The present invention will further be described with particular reference to a photo-electrochemical cell to which the electrolyte of the invention is applied for preference.

The photo-electrochemical cell of the invention comprises a semiconductor responsive to a radiant ray, a charge transporting layer, and a counter electrode. The charge transporting layer contains the above described electrolyte.

The semiconductor in the cell serves as a photoreceptor that absorbs light to generate electrons and positive holes. The semiconductor which can be used in the invention includes simple substance semiconductors, e.g., Si or Ge, compound semiconductors, such as metal chalcogenides (e.g., oxides, sulfides, and selenides), and perovskite semiconductors. The metal chalcogenides include an oxide of titanium, tin, zinc, iron, tungsten, zirconium, hafnium, strontium, indium, cerium, yttrium, lanthanum, vanadium, niobium or tantalum; a sulfide of cadmium, zinc, lead, silver, antimony or bismuth; a selenide of cadmium or lead; and cadmium telluride. Other compound semiconductors include a phosphide of zinc, potassium, indium or cadmium, gallium arsenide, copper indium selenide, and copper indium sulfide. The perovskite semiconductors include strontium titanate, calcium titanate, sodium titanate, barium titanate, and potassium niobate.

Preferred semiconductors for use in the invention include Si, TiO₂, SnO₂, Fe₂O₃, WO₃, ZnO, Nb₂O₅, CdS, ZnS, Pbs, Bi₂S₃, CdSe, GaP, InP, GaAs, CdTe, CuInS₂, and CuInSe₂. Still preferred are TiO₂, ZnO, SnO₂, Fe₂O₃, WO₃, Nb₂O₅, CdS, PbS, CdSe, InP, GaAs, CuInS₂, and CuInSe₂.

The semiconductor may be a single crystal or polycrystalline. A single crystal is preferred for conversion efficiency, while a polycrystalline semiconductor is preferred from the standpoint of production cost, supply of raw materials, and an energy payback time. Finely particulate semiconductors having a particle size on the order of nanometers to microns are particularly preferred. The particulate semiconductors preferably have an average primary particle size of 5 to 200 nm, particularly 8 to 100 nm, in terms of a projected circle-equivalent diameter. The semiconductor particles in a dispersed state preferably have an average particle size of 0.01 to 100 µm.

It is preferred for the particulate semiconductors, particularly metal oxide semiconductors, to be sensitized with dyes. For example, TiO₂, ZnO, SnO₂, Fe₂O₃, WO₃, and Nb₂O₅ are preferred semiconductors to be dye-sensitized. TiO₂ is particularly preferred to be dye-sensitized.

The photo-electrochemical cells using dye-sensitized semiconductor particles will be illustrated in more detail. The photo-electrochemical cell using dye-sensitized semiconductor particles is preferably composed of (a) an electrically conductive substrate and a photosensitive layer provided on the conductive substrate (i.e., a layer of semiconductor particles having adsorbed thereon a dye), (b) a charge transporting layer containing the compound (I') (preferably the compound (II'), still preferably the compound (III')), and (c) a counter electrode. The charge transporting layer does not need to be an independent layer with a distinct border. For example, a part or the whole of the electrolyte may penetrate the particulate semiconductor layer to form a charge transporting layer.

The electrically conductive substrate includes a substrate made of a conductive material, such as metal, and a nonconductive substrate made of glass or plastics having on the surface thereof an electrical conductor layer. Preferred conductors for use in the latter type of conductive substrates include metals (e.g., platinum, gold, silver, copper, aluminum, rhodium, and indium), carbon, and electrically conducting metal oxides (e.g., indium-tin composite oxide and F-doped tin oxide). Of the above conductive substrates particularly preferred is a conductive glass substrate obtained by depositing F-doped tin dioxide on a transparent substrate made of inexpensive soda-lime float glass. The conductor layer preferably has a thickness of about 0.02 to 10 µm.

The conductive substrate preferably has as low a surface resistivity as possible. A desirable surface resistivity is 100 Ω/cm² or smaller, particularly 40 Ω/cm² or smaller. While not limiting, the practical minimal surface resistivity is about 0.1 Ω/cm².

It is preferred that the conductive substrate be substantially transparent to light. The term "substantially transparent" means that the light transmission is at least 10%, preferably 50% or more, still preferably 70% or more. A glass or plastic substrate having an electrically conductive metal oxide layer is preferred as a transparent substrate. The amount of the conductive metal oxide is preferably 0.01 to 100 g/m². The transparent conductive substrate is preferably used in such a manner that incident light enters from the side of the glass or plastic substrate.

The semiconductor particles are applied to the conductive substrate by, for example, a method comprising coating the conductive substrate with a dispersion or colloidal solution of the semiconductor particles or a sol-gel process comprising applying a precursor of the semiconductor particles onto the conductive substrate and hydrolyzing the precursor with moisture in air to form a particulate semiconductor film. A dispersion of the semiconductor particles is prepared by the above-mentioned sol-gel process, a method comprising grinding a semiconductor in a mortar, or a method comprising wet grinding a semiconductor in a mill. A synthetic semiconductor as precipitated in a solvent in the form of fine particles can also be used as such. Useful dispersing media include water and various organic solvents, such as methanol, ethanol, isopropyl alcohol, dichloromethane, acetone, acetonitrile, and ethyl acetate. In preparing a dispersion, a polymer, a surface active agent, an acid, a chelating agent, and the like may be added as a dispersing aid if desired.

It is preferable for the semiconductor particles to have a large surface area so that they may adsorb as large an amount of a dye as possible. The surface area of the semiconductor particles in the state applied to the conductive substrate is preferably 10 times or more, still preferably 100 times or more, the projected area. The upper limit of the surface area is, while not limited, practically about 1000 times the projected area.

In general, as the thickness of the particulate semiconductor layer increases, the amount of the supported dye per unit projected area increases to show increased ability of capturing light, but the distance of diffusion of generated electrons also increases, which results in an increased loss due to re-coupling of charges. Accordingly, there is a favorable thickness range for the particulate semiconductor layer, which is typically from 0.1 to 100 µm. For use in a photo-electrochemical cell, the thickness is preferably 1 to 30 µm, still preferably 3 to 20 µm. It is preferred that the semiconductor particles applied to the substrate be calcined so that the particles may be brought into electronic contact among themselves to secure improved film strength and improved adhesion to the substrate. A preferred calcined temperature is 40°C or higher and lower than 700°C, particularly from 40 to 650°C. The calcined time is usually from 10 minutes to about 10 hours. For the purpose of increasing the surface area of the semiconductor particles and of increasing the purity in the vicinities of the semiconductor particles thereby to improve electron injection efficiency from the dye to the semiconductor particles, the calcined particulate semiconductor layer can be subjected to chemical plating with a titanium tetrachloride aqueous solution or electrochemical plating with a titanium trichloride aqueous solution.

The amount of the semiconductor particles to be applied is preferably 0.5 to 500 g/m², still preferably 5 to 100 g/m².

The dye which can be used in the present invention preferably includes complex dyes (particularly metal complex dyes) and/or polymethine dyes. It is preferred for the dye to have an appropriate interlocking group for linking to the surface of the semiconductor particles. Preferred interlocking groups include -COOH, -SO₃H, a cyano group, -P(O)(OH)₂, -OP(O)(OH)₂, and chelating groups having pi conductivity, such as oxime, dioxime, hydroxyquinoline, salicylate and α-keto-enolate groups. Particularly preferred of them are -COOH, -P(O)(OH)₂, and -OP(O)(OH)₂. The interlocking group may be in the form of a salt with an alkali metal, etc. or an intramolecular salt. Where the methine chain of a polymethine dye has an acidic group as in the case where the methine chain forms a squarylium ring or a croconium ring, that moiety can be used as a interlocking group.

The metal complex dyes preferably include ruthenium complex dyes. Those represented by formula (V) are still preferred.

(Y₁)ₚRuBₐB_{b}B_{c} (V)

wherein Y₁ represents a ligand selected from the group consisting of C1, SCN, H₂O, Br, I, CN, -NCO and SeCN; p represents an integer of 0 to 2, preferably 2; and Bₐ, B_{b}, and B_{c} each represent an organic ligand selected from B-1 to B-8 shown below. 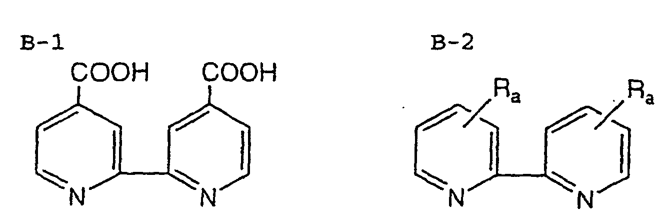 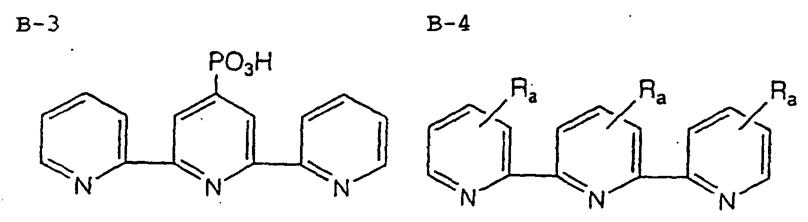 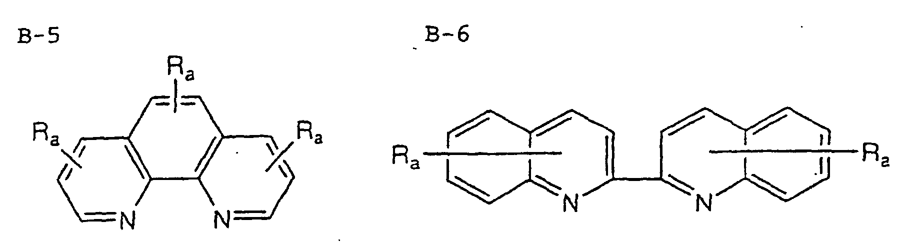 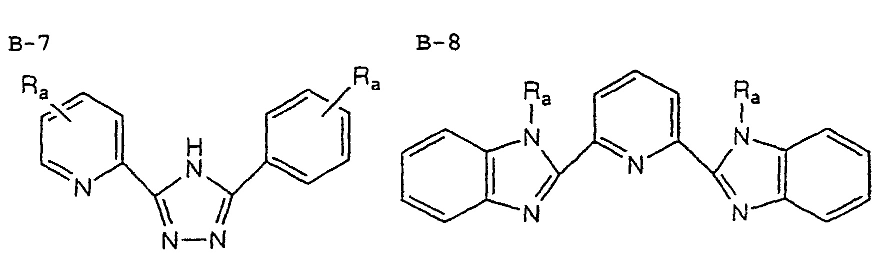 wherein Rₐ represents a hydrogen atom, a halogen atom, a substituted or unsubstituted alkyl group having 1 to 12 carbon atoms, a substituted or unsubstituted aralkyl group having 7 to 12 carbon atoms or a substituted or unsubstituted aryl group having 6 to 12 carbon atoms. The alkyl group and the alkyl moiety of the aralkyl group may be either straight or branched, and the aryl group and the aryl moiety of the aralkyl group may be either monocyclic or polycyclic (condensed rings or independent rings).

Examples of useful ruthenium complex dyes used in the present invention are given in U.S. Patents 4,927,721, 4,684,537, 5,084,365, 5,350,644, 5,463,057, and 5,525,440 and JP-A-7-249790. Specific examples of preferred ruthenium complex dyes represented by formula (V) are tabulated below.

**TABLE 1**

| (Y₁)ₚRuBₐB_{b}B_{c} | | | | | | |
|---|---|---|---|---|---|---|
| NO. | Y₁ | p | Bₐ | B_{b} | B_{c} | Rₐ |
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | Br | 2 | B-1 | B-1 | - | - |
| R-5 | I | 2 | H-1 | B-1 | - | - |
| R-6 | SCN | 2 | H-1 | B-2 | - | H |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 2 | B-1 | B-6 | - | H |
| R-11 | CN | 2 | B-1 | B-7 | - | H |
| R-12 | Cl | 1 | B-1 | B-8 | - | H |
| R-13 | - | 0 | B-1 | B-1 | B-1 | - |

Specific examples of other suitable metal complex dyes are shown below.

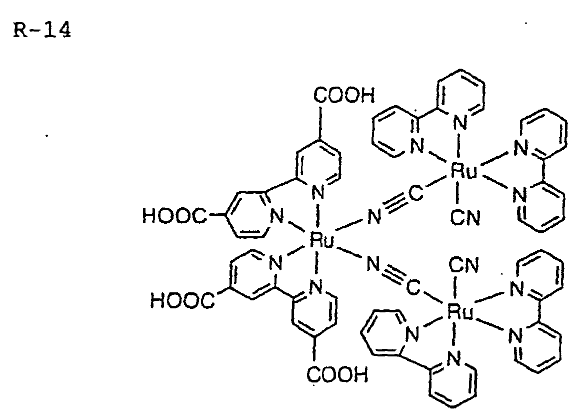

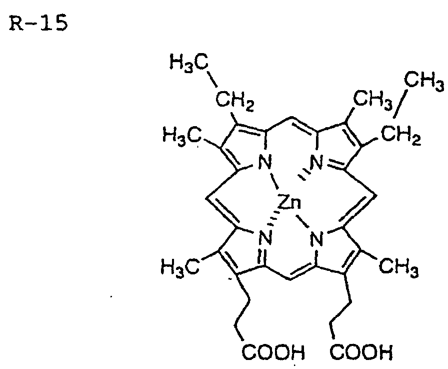

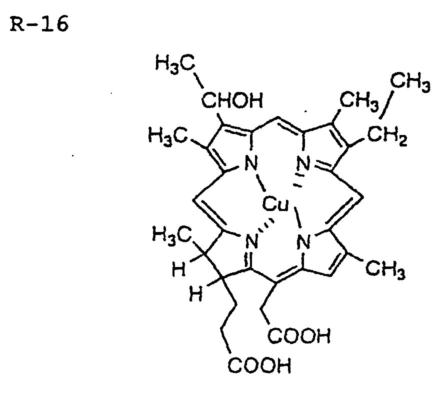

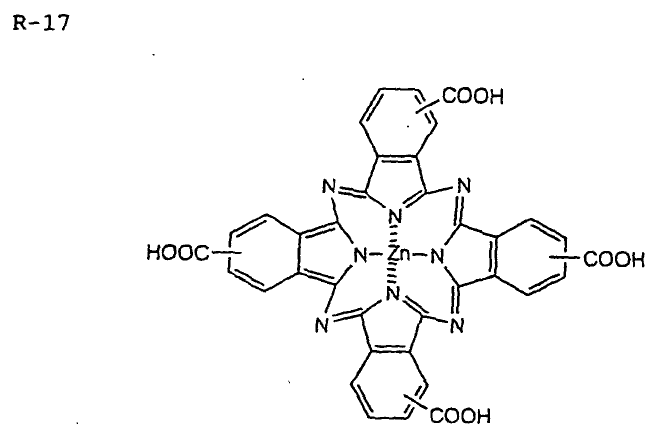

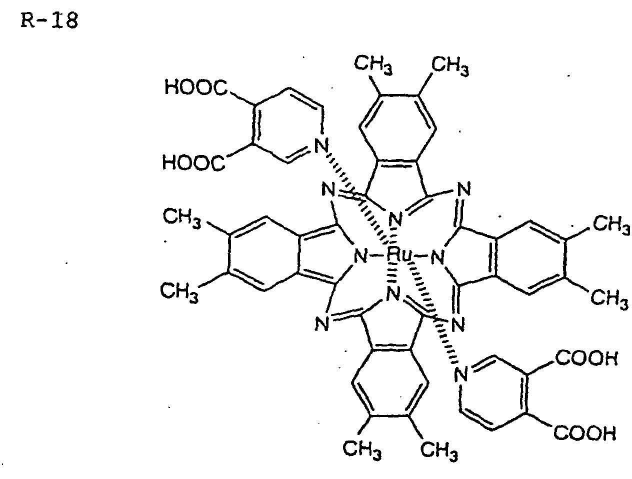

The polymethine dyes preferably include those represented by formulae (VI) and (VII) shown below. 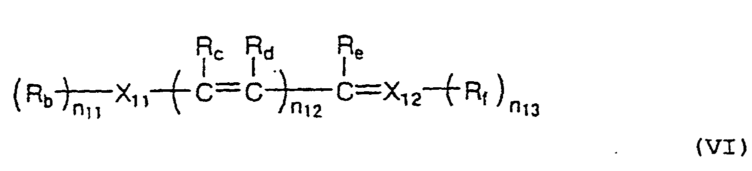 wherein R_{b} and R_{f} each represent a hydrogen atom, an alkyl group, an aryl group or a heterocyclic group; R_{c}, R_{d}, and Rₑ each represent a hydrogen atom or a substituent; R_{b}, R_{c}, R_{d}, Rₑ, and R_{f} may appropriately be taken together to form a ring; X₁₁ and X₁₂ each represent a nitrogen atom, an oxygen atom, a sulfur atom, a selenium atom or a tellurium atom; n11 and n13 each represent an integer of 0 to 2; and n12 represents an integer of 1 to 6.

The compound of formula (VI) may have a counter ion in agreement with the charge quantity of the whole molecule. In formula (VI), the alkyl, aryl, and heterocyclic groups may have a substituent; the alkyl group may be straight or branched; the aryl and heterocyclic groups may be monocyclic or polycyclic (condensed rings); and the ring formed of R_{b}, R_{c}, R_{d}, Rₑ, and R_{f} may have a substituent and may be monocyclic or polycyclic. 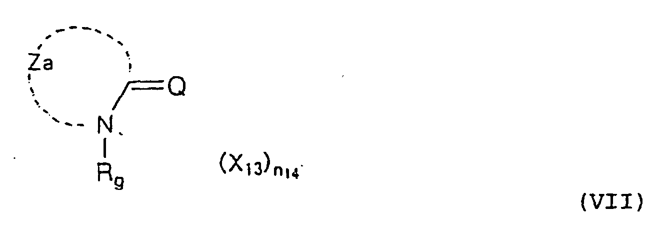 wherein Zₐ represents a non-metal atomic group necessary to form a nitrogen-containing heterocyclic group; R_{g} represents an alkyl group or an aryl group; Q represents a mono- or polymethine group necessary to complete a (poly)methine dye; X₁₃ represents a counter ion in balance; and n14 represents a number of from 0 up to 10 that is necessary to neutralize the charge of the molecule.

In formula (VII), the nitrogen-containing heterocyclic ring formed by Za may have a substitutent and may be a single ring or a condensed ring; the alkyl or aryl groups may have a substituent; the alkyl group may be straight or branched; and the aryl group may be monocyclic or polycyclic (condensed rings).

The dyes represented by formula (VII) preferably include those represented by formulae (VIII-a) through (VIII-d): 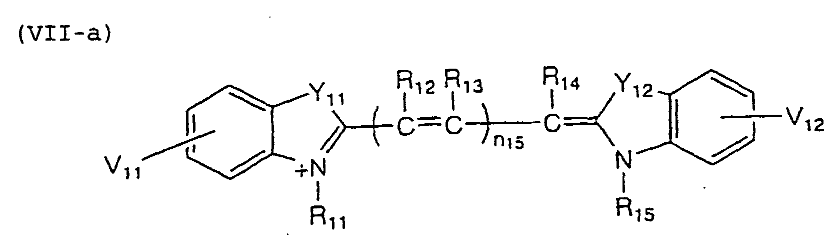 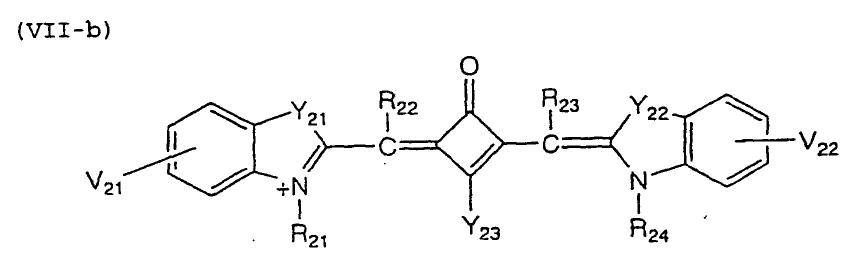 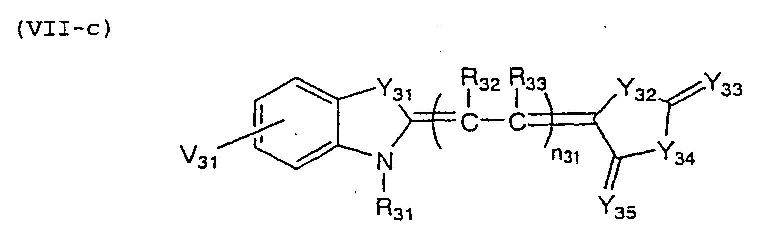 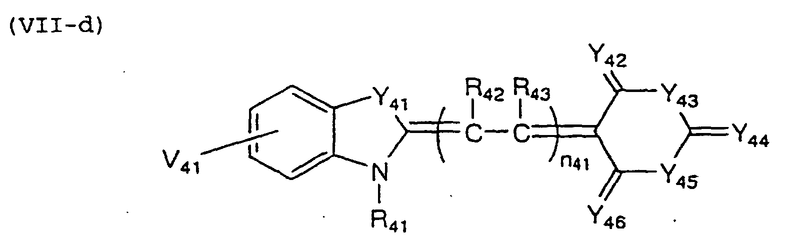 wherein R₁₁, R₁₂, R₁₃, R₁₄, R₁₅, R₂₁, R₂₂, R₂₃, R₂₄, R₃₁, R₃₂, R₃₃, R₄₁, R₄₂, and R₄₃ each represent a hydrogen atom, an alkyl group, an aryl group or a heterocyclic group; Y₁₁, Y₁₂, Y₂₁, Y₂₂, Y₃₁, Y₃₂, Y₃₃, Y₃₄, Y₃₅, Y₄₁, Y₄₂, Y₄₃, Y₄₄, Y₄₅, and Y₄₆ each represent an oxygen atom, a sulfur atom, a selenium atom, a tellurium atom, -CR₁₆R₁₇- or -NR₁₈-; R₁₆, R₁₇, and R₁₈ each represent a hydrogen atom, an alkyl group, an aryl group or a heterocyclic group; Y₂₃ represents O⁻, S⁻, Se⁻, Te⁻ or -NR₁₈⁻; V₁₁, V₁₂, V₂₁, V₂₂, V₃₁, and V₄₁ each represent a substituent; and n15, n31, and n41 each represent an integer of 1 to 6.

The compounds represented by formulae (VIII-a) through (VIII-d) may have a counter ion in agreement with the charge quantity of the whole molecule. In these formulae, the alkyl, aryl, and heterocyclic groups may have a substituent; the alkyl group may be straight or branched; and the aryl or heterocyclic group may be monocyclic or polycyclic (condensed rings).

Examples of the above-described polymethine dyes are given in M. Okawara, T. Kitao, T. Hirashima, and M. Matuoka, Organic Colorants, Elsevier.

Specific but non-limiting examples of preferred polymethine dyes represented by formulae (VI) and (VII) are shown below.

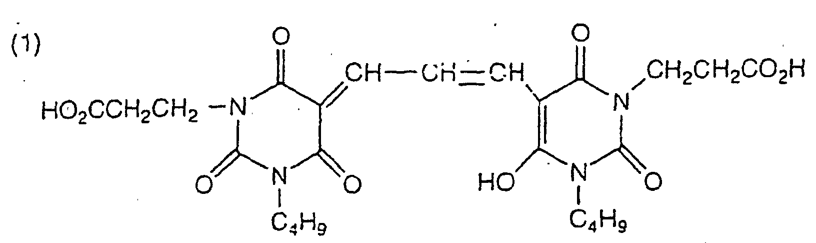

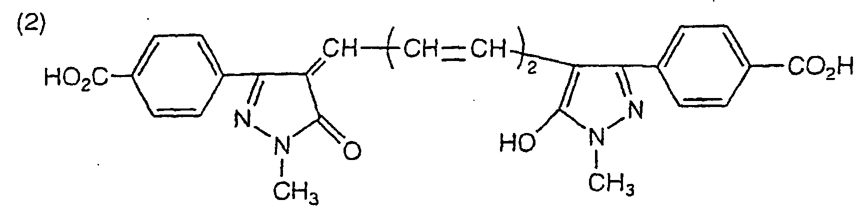

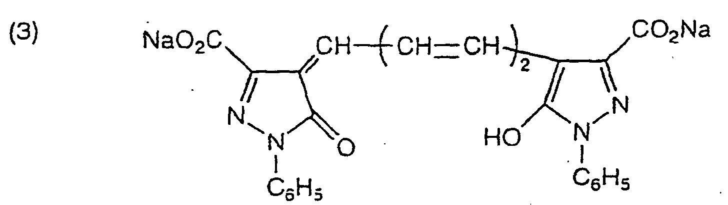

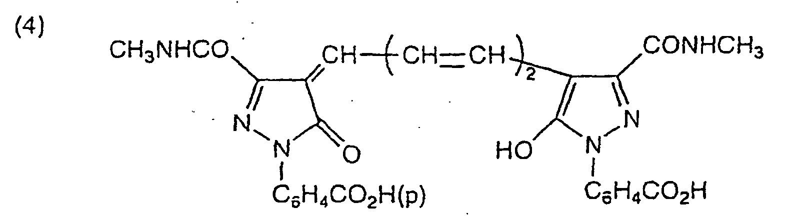

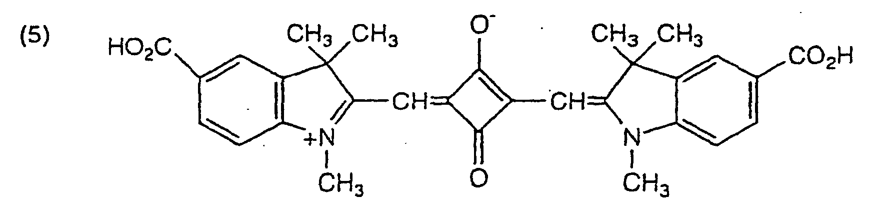

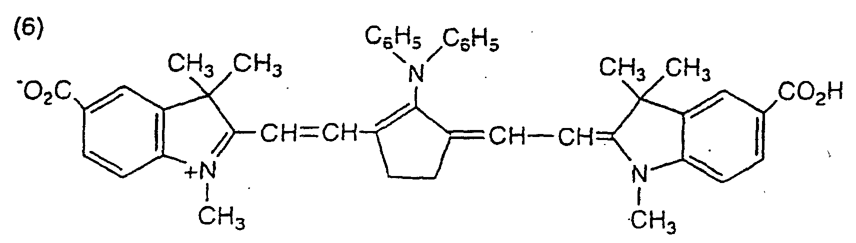

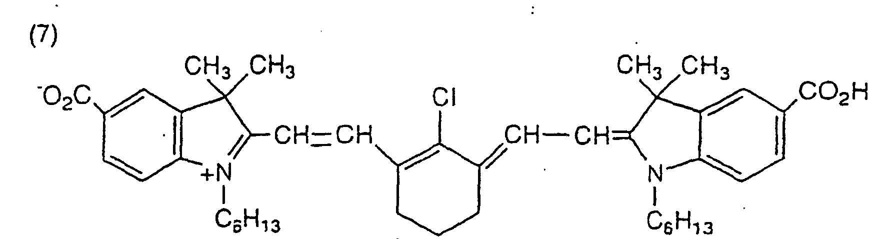

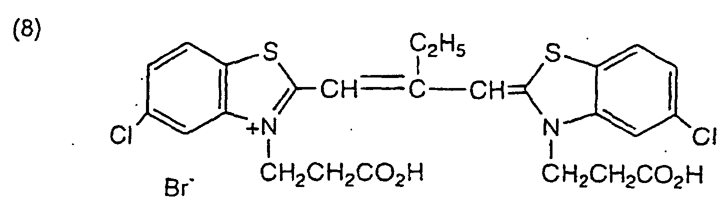

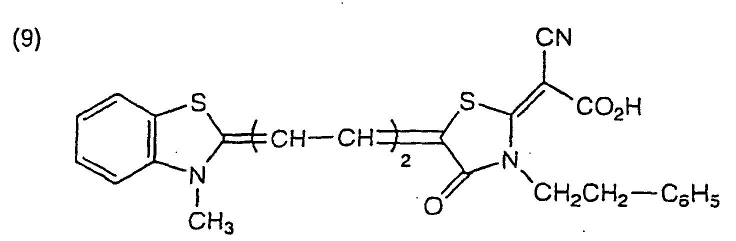

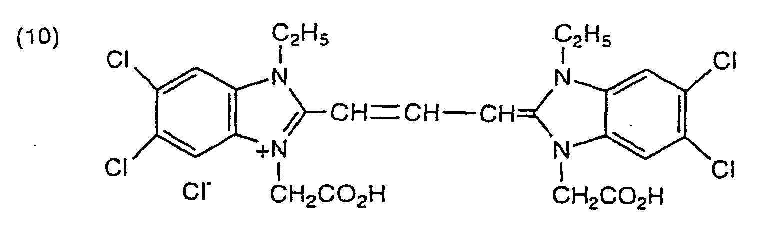

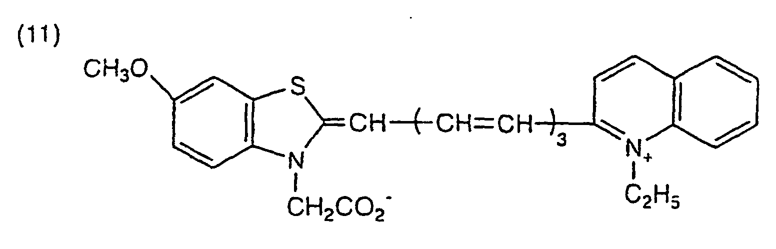

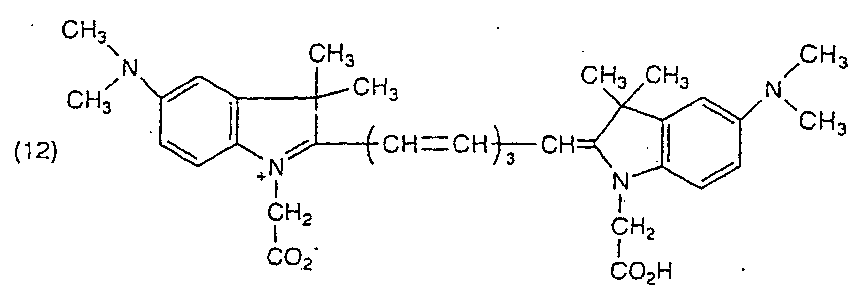

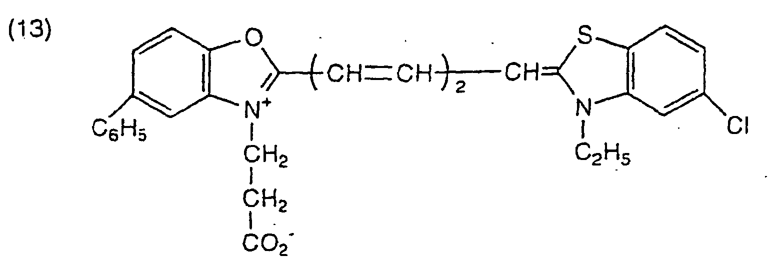

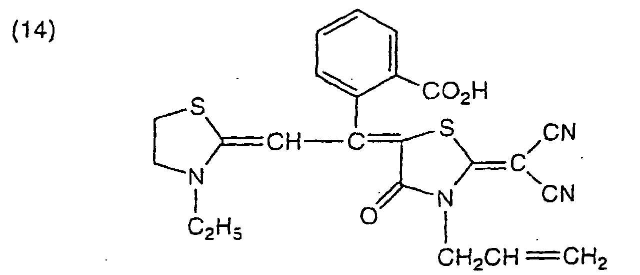

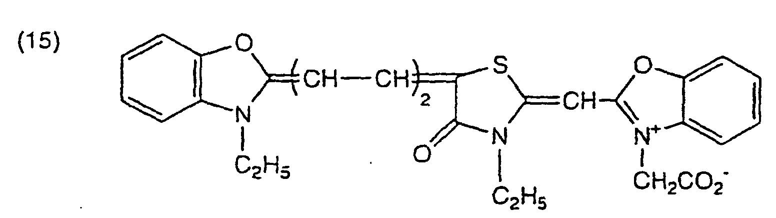

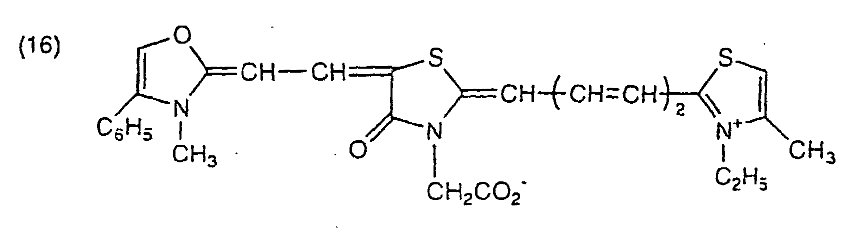

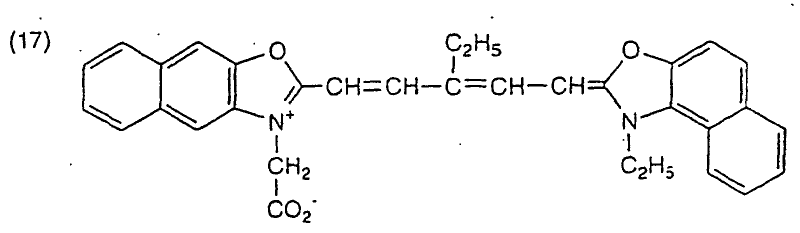

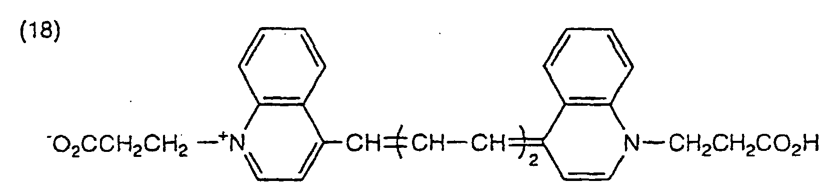

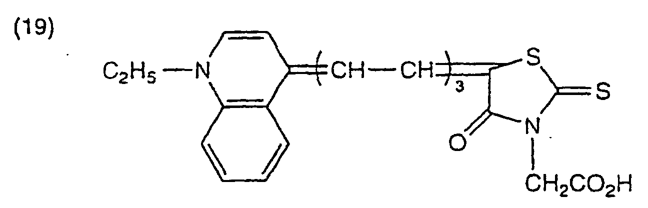

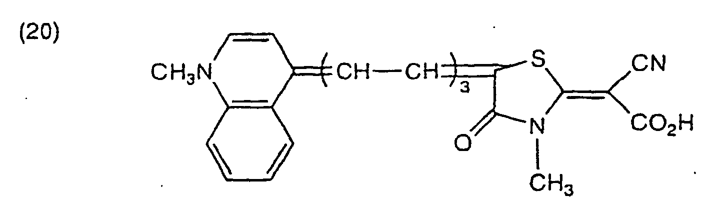

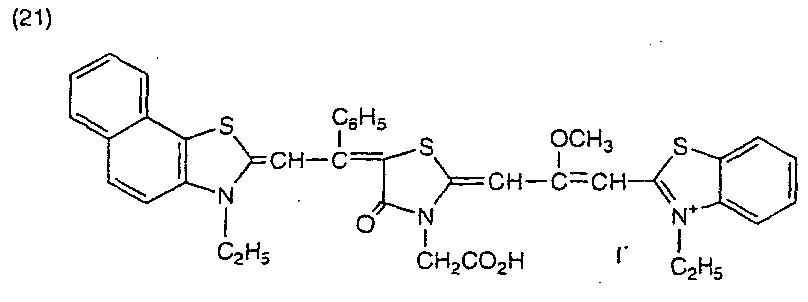

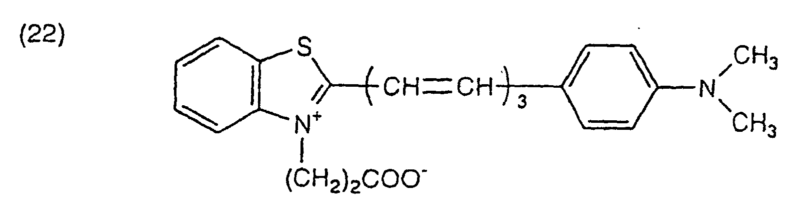

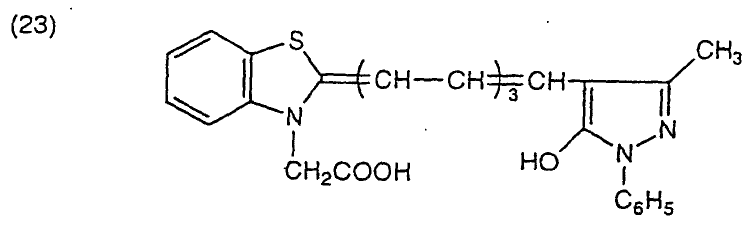

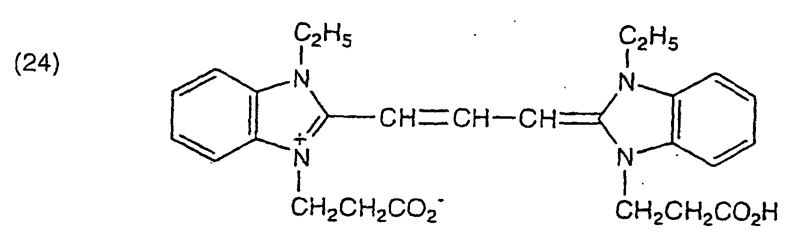

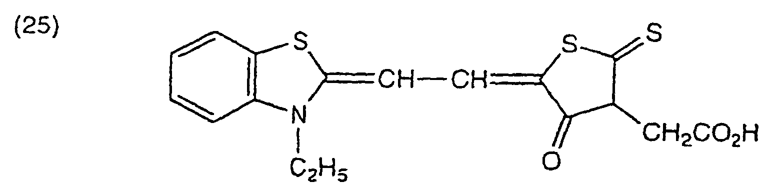

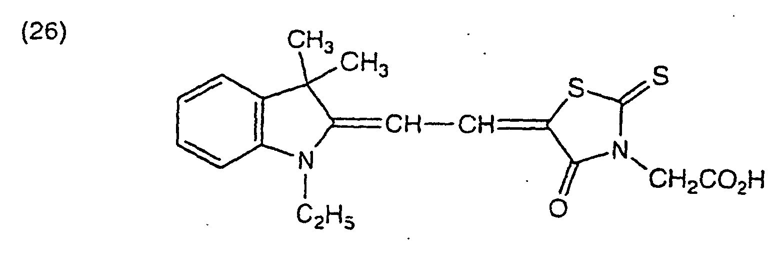

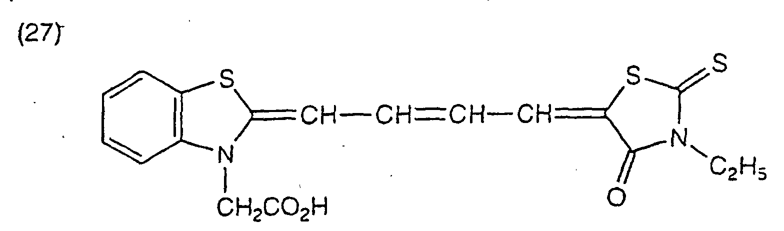

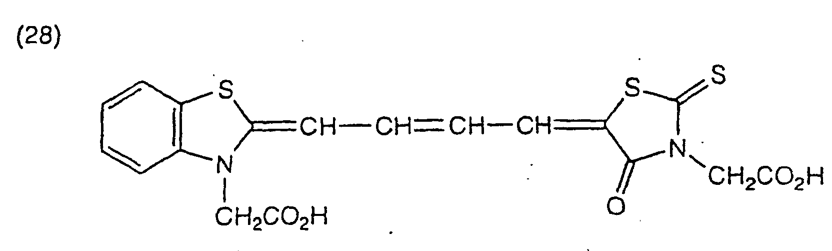

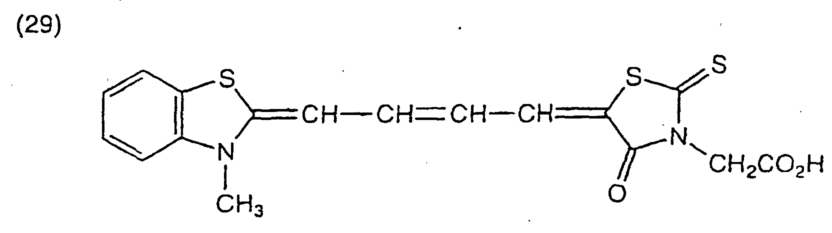

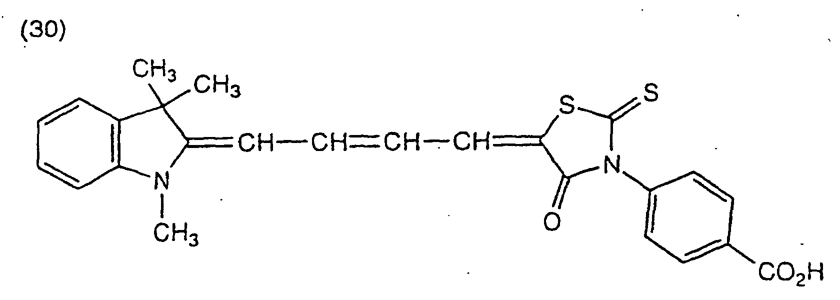

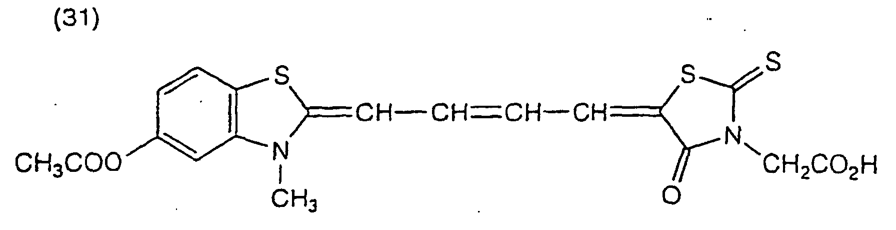

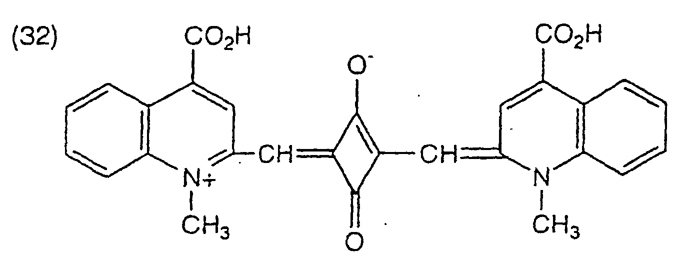

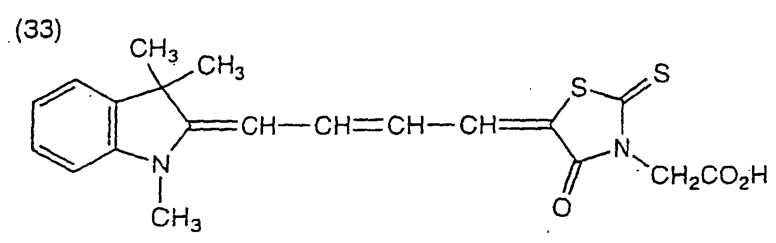

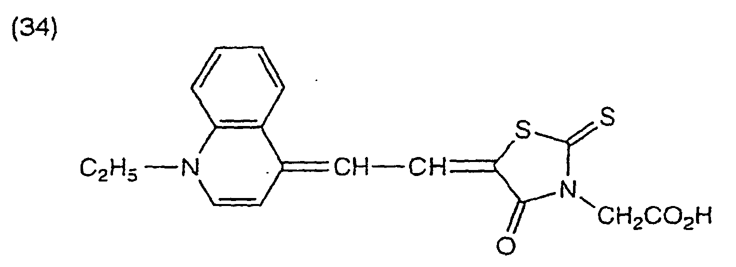

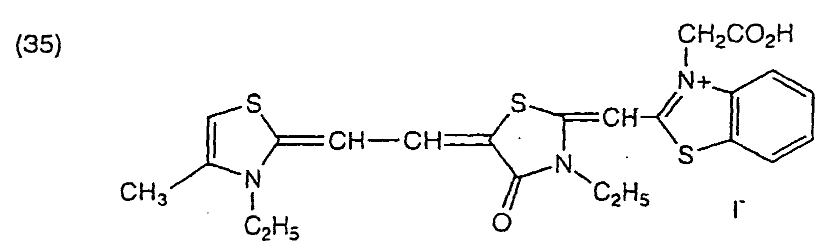

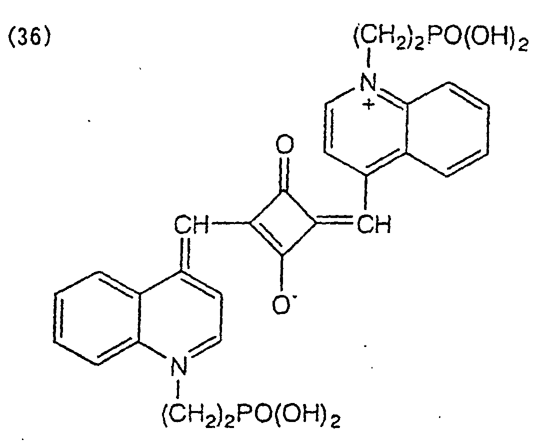

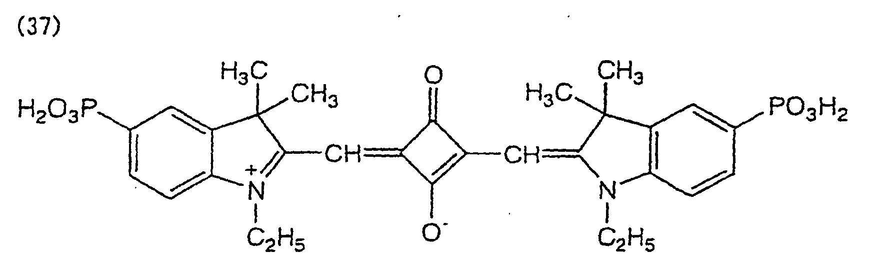

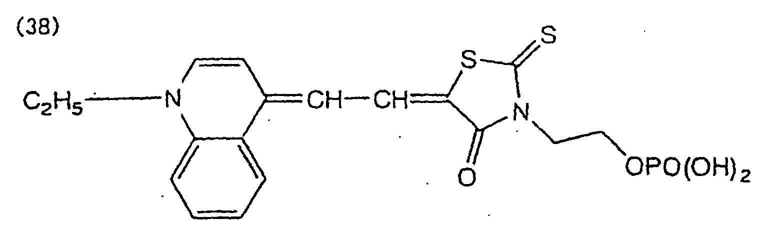

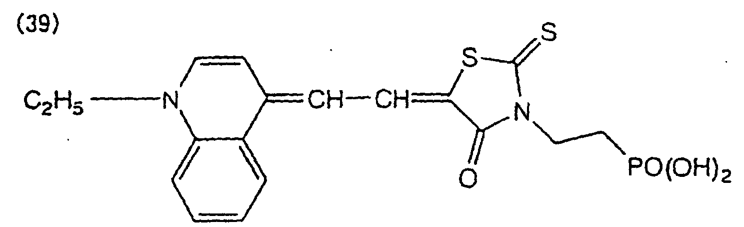

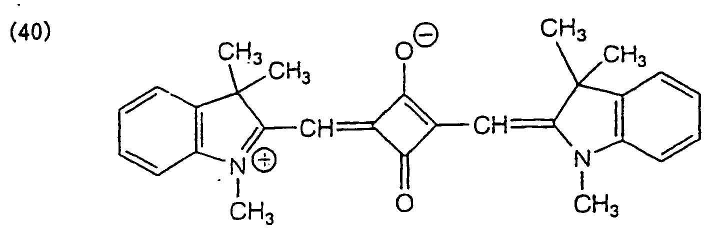

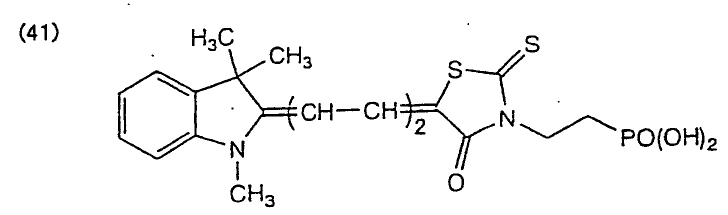

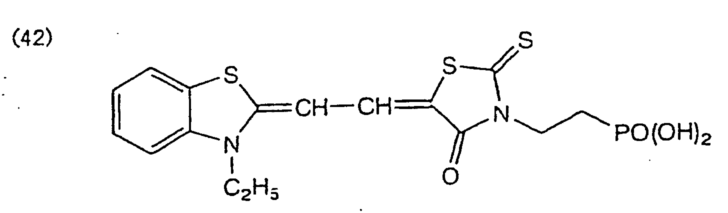

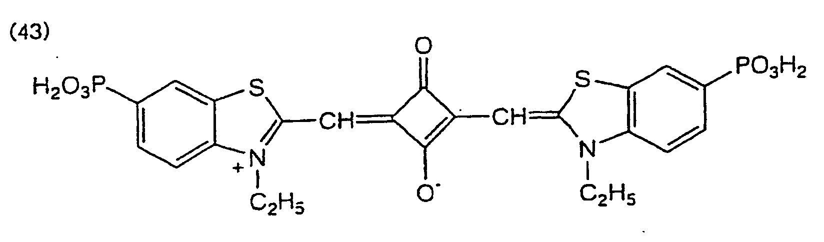

The compounds of formulae (VI) and (VII) can be synthesized in accordance with the methods described, e.g., in F.M. Harmer, *Heterocyclic Compounds-Cyanine Dyes and Related Compounds*, John Wiley & Sons, New York & London (1964); D.M. Sturmer, *Heterocyclic Compounds-Special topics in heterocyclic chemistry*, Ch. 18, §14, Items 482-515, John Wiley & Sons, New York & London (1977); *Rodd's Chemistry of Carbon Compounds*, 2nd Ed., vol. IV, part B, Ch. 15, Items 369-422, Elsevier Science Publishing Co., Inc., New York (1977); and British Patent 1,077,611.

Adsorption of the dye onto semiconductor particles is usually effected by immersing well-dried semiconductor particles in a dye solution for several hours at room temperature or, as taught in JP-A-7-249790, while refluxing. Dye adsorption may be carried out either before or after applying the semiconductor particles to the substrate or simultaneously with application of the semiconductor particles. The unadsorbed dye is preferably removed by washing. Where the applied semiconductor particles are to be subjected to calcining, dye adsorption is preferably conducted after the calcining. It is particularly preferred that the dye be adsorbed quickly before water is adsorbed to the surface of the calcined semiconductor layer. The dyes may be used either individually or as a combination of two or more thereof. Where the dye-sensitized photoelectric device is for a photo-electrochemical cell, the dyes to be combined can be selected so as to maximize the breadth of the wavelength region for photoelectric conversion.

In order to obtain a sufficient sensitizing effect, the dye or dyes are preferably used in an amount of 0.01 to 100 mmol per m² of the substrate and 0.01 to 1 mmol per gram of the semiconductor particles. With too small an amount of the dye, the sensitizing effect would be insufficient. If the dye is used in too large an amount, the non-adsorbed dye will float to reduce the sensitizing effect.

A colorless compound may be adsorbed together with the dye so as to lessen the interaction among dye molecules, such as association. Hydrophobic compounds such as carboxyl-containing steroid compounds (e.g., cholic acid) can be used for this purpose.

After dye adsorption, the surface of the semiconductor particles can be treated with an amine, such as pyridine, 4-t-butylpyridine or polyvinylpyridine. The amine can be used as such where it is liquid, or as dissolved in an organic solvent.

The compound (I') is used as an electrolyte compound which constitutes the charge transporting layer of the photo-electrochemical cell. Compared with general low-molecular solvents, the compound (I') is less volatile because of their higher boiling point and higher viscosity. To have less volatility is effective on improvement of durability, and to have higher viscosity is in favor of suitability to production.

It is preferable for durability, photoelectric conversion efficiency and production suitability that 50% by weight or more, desirably 70% by weight or more, more desirably 80% by weight or more, the most desirably 90% by weight or more, of the electrolyte which forms the charge transporting layer is the compound (I').

The compound (I') is preferably a so-called molten salt that is liquid at 25°C or low-melting point solid at 25°C. Having such a character, the compound (I') can form an electrolyte by itself, requiring almost no solvent. Having an extremely higher boiling point than general solvents, the compound (I') exhibits low volatility and is effective in preventing deterioration of cell performance by volatilization. Since the compound (I') shows a high short circuit current density as well as improved durability, it provides a photo-electrochemical cell having excellent photoelectric conversion characteristics with high suitability to production.

The compound (I') preferably has a melting point of 100°C or lower, more preferably 80°C or lower, most preferably 60°C or lower. The compound (I') includes those which are liquid at 25°C, as stated above. The compound (I') preferably has a boiling point (normal boiling point) of 300°C or higher, particularly 400°C or higher.

Of the compounds (I'), those which are liquid at 25°C, for example, F'-1, F'-4, F'-5, and F'-15 are preferred for improving the initial performance such as a short circuit current, while those which are solid at 25°C, for example, F'-6, F'-9, and F'-13 are preferred for improving the durability.

Many of the compounds (I') which are solid at 25°C can perform their function as an electrolyte as liquefied by addition of the solvent, water or other additives. In some cases, the compound can melt on heating of itself and penetrate the electrode. Or, the compound can be once dissolved in a low-boiling solvent (e.g., methanol, acetonitrile or methylene chloride) and, after penetration into the electrode, the low-boiling solvent is removed by heating. Many of the compounds (I') have some hygroscopicity. They can be used as having a water content of about 0.1 to 15% by weight.

The compound (I') is used as an electrolyte compound capable of performing the function of an electrolyte (hereinafter referred to as an electrolyte component). While it is desirable that the compound (I') be a sole electrolyte component of the electrolyte, other electrolyte components can be used in combination, if desired. Other electrolyte components which can be used in combination include metal iodides, such as LiI, NaI, KI, CsI, and CaI₂; an iodine salt of quaternary ammonium compounds (e.g., a pyridinium compound or a tetraalkylammonium compound); Br₂ and a metal bromide, such as LiBr, NaBr, KBr, CsBr or CaBr₂; Br₂ and a bromine salt of a quaternary ammonium compound, such as a tetraalkylammonium bromide or pyridinium bromide; metal complexes, such as a ferrocyananate-ferricyanate or a ferrocene-ferricinium ion; sulfur compounds, such as poly(sodium sulfite) and an alkylthiol-alkyl disulfide; viologen dyes; hydroquinone-quinone, and the like. The proportion of these other electrolyte components in the total electrolyte components is preferably up to 30% by weight.

The electrolyte can contain a solvent in a proportion, at the highest, equal to the proportion of the compound (I'). The solvent that can be used in the electrolyte is preferably a compound having excellent ion conductivity. In order to exhibit excellent ion conductivity, it is preferred for the solvent to have a low viscosity and/or a high dielectric constant. To have a low viscosity leads to an improvement in ion mobility. To have a high dielectric constant brings about an increase in effective carrier concentration. Suitable examples of the solvents include carbonate compounds, e.g., ethylene carbonate and propylene carbonate; heterocyclic compounds, e.g., 3-methyl-2-oxazolidinone; ether compounds, e.g., dioxane and diethyl ether; chain ethers, e.g., ethylene glycol dialkyl ether, propylene glycol dialkyl ether, polyethylene glycol dialkyl ether, and polypropylene glycol dialkyl ether; alcohols, e.g., methanol, ethanol, ethylene glycol monoalkyl ether, propylene glycol monoalkyl ether, polyethylene glycol monoalkyl ethers, and polypropylene glycol monoalkyl ether; polyhydric alcohols, e.g., ethylene glycol, propylene glycol, polyethylene glycol, polypropylene glycol, and glycerol; nitrile compounds, e.g., acetonitrile, glutarodinitrile, methoxyacetonitrile, propionitrile, and benzonitrile; esters, e.g., carboxylic acid esters, phosphoric acid esters, and phosphonic acid esters; aprotic polar compounds, e.g., dimethyl sulfoxide and sulfolane; and water. Preferred of them are carbonate compounds, such as ethylene carbonate and propylene carbonate; heterocyclic compounds, such as 3-methyl-2-oxazolidinone; nitrile compounds, such as acetonitrile, glutarodinitrile, methoxyacetonitrile, propionitrile, and benzonitrile; and esters. These solvents can be used either individually or as a combination of two or more thereof.

Specific but non-limiting examples of preferred solvents are shown below.

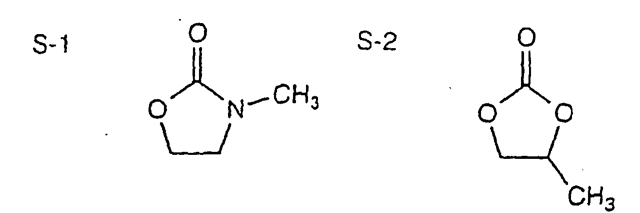

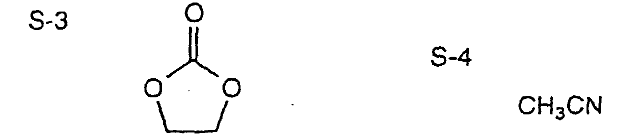

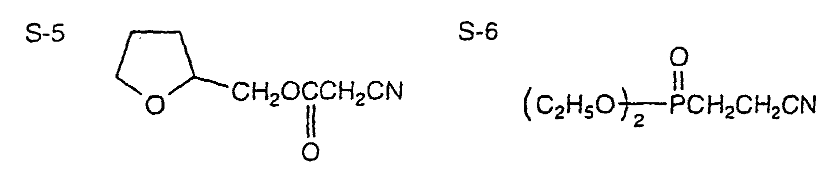

S-7 CH₃OCH₂CH₂OCH₃

From the standpoint of volatility resistance, which is in favor of durability, the boiling point of the solvent is preferably 200°C or higher, still preferably 250°C or higher, particularly preferably 270°C or higher, under atmospheric pressure (i.e., 1 atm). Accordingly, S-5 and S-6 are preferred.

The charge transporting layer is preferably 0.001 to 200 µm, still preferably 0.1 to 100 µm, in thickness.

The counter electrode in the photo-electrochemical cell functions as a positive electrode. The counter electrode usually has a conductive substrate, such as those described above, but a substrate is not always required as far as sufficient strength is secured. For achieving air tightness, use of a substrate is advantageous, though.

At least one of the conductive substrate of the conductive electrode and the counter electrode must be substantially transparent so that incident light can reach the photosensitive layer. It is preferred for the photo-electrochemical cell of the invention that the conductive substrate be transparent and that light be incident upon this side. In this case, it is still preferred that the counter electrode have light reflecting properties.

The counter electrode that can be used in the photo-electrochemical cell includes glass or plastic having metal or a conductive oxide deposited thereon. Metal can be deposited by vacuum evaporation, sputtering or a like technique for thin film formation to a deposit thickness of 5 µm or smaller, preferably 5 nm to 3 µm. A preferred counter electrode is a glass plate having platinum deposited thereon by vacuum evaporation or a metal thin film formed by vacuum evaporation or sputtering.

The photosensitive layer may have a single layer structure or a multilayer structure as designed according to the end use. A single photosensitive layer may have a dye of a kind or a mixture of two or more kinds of dyes.

The photo-electrochemical cell of the invention may have its sides sealed with a polymer, an adhesive, etc. to prevent oxidative deterioration.

Preferred embodiments of the present invention are shown in items 13 to 18 below.
(1) An electrolyte containing the compound (I').
(2) The electrolyte according to (1), wherein the compound (I') is the compound (II').
(3) The electrolyte according to (2), wherein the compound (II') is the compound (III').
(4) An electrolyte according to (3), wherein R₃' is a butyl group, a hexyl group or an octyl group.
(5) The electrolyte according to (3) or (4), wherein R₄' is a methyl group, an ethyl group, a cyanomethyl group, a methoxycarbonyl group or an ethoxycarbonyl group.
(6) The electrolyte according to any of (3) to (5), wherein R₃' is an unsubstituted straight-chain alkyl group having 4 to 8 carbon atoms, and R₄' is a methyl group.
(7) The electrolyte according to any of (1) to (6), wherein the compound (I') is present in a proportion of 50% by weight or more based on the electrolyte.
(8) The electrolyte according to (7), wherein the compound (I') is present in a proportion of 80% by weight or more based on the electrolyte.
(9) The electrolyte according to (8) which is liquid at 25°C.
(10) The electrolyte according to any of (1) to (9), wherein the compound (I') is liquid at 25°C.
(11) The electrolyte according to any of (1) to (9), wherein the compound (I') is solid at 25°C and has a melting point of 100°C or lower.
(12) The electrolyte according to any of (1) to (11) which is for a photo-electrochemical cell.
(13) A photo-electrochemical cell comprising a semiconductor responsive to a radiant ray, a charge transporting layer, and a counter electrode, wherein the charge transporting layer contains an electrolyte according to (12).
(14) The photo-electrochemical cell according to (13), wherein the semiconductor is a dye-sensitized particulate semiconductor.
(15) The photo-electrochemical cell according to (14), wherein the particulate semiconductor is a metal chalcogenide.
(16) The photo-electrochemical cell according to (15), wherein the metal chalcogenide contains titanium oxide.
(17) The photo-electrochemical cell according to any of (14) to (16), wherein the dye is a metal complex dye and/or a polymethine dye.
(18) A pyridinium compound represented by formula (IV').

### EXAMPLE

The present invention will now be illustrated in greater detail with reference to Synthesis Examples and Examples, but it should be understood that the invention is not limited thereto.

### EXAMPLE 1

### 1) Preparation of titanium dioxide dispersion

In a 200 ml-volume stainless steel-made vessel having its inner wall coated with Teflon were charged 15 g of titanium dioxide (Degussa P-25, produced by Nippon Aerosil Co., Ltd.), 45 g of water, 1 g of a dispersant (Triton X-100, produced by Aldrich), and 30 g of zirconia beads having a diameter of 0.5 mm (produced by Nikkato Corp.) and dispersed by means of a sand grinder mill (produced by Imex Co., Ltd.) at 1500 rpm for 2 hours. The zirconia beads were filtered off the dispersion. The average particle size of the dispersed titanium dioxide particles was 2.5 µm as measured with Mastersizer manufactured by Malvern.

### 2) Preparation of dye-sensitized TiO₂ electrode

Electrically conductive glass having an F-doped tin oxide coat (TCO Glass-U, produced by Asahi Glass Co., Ltd.; surface resistivity: about 30 Ω/cm²) was cut to squares with 20 mm-sides. The titanium dioxide dispersion prepared in item 1) was applied with a glass bar to the conductive side of 8 glass pieces at a time in the following manner. An adhesive tape was stuck to one end (over a 3 mm width from the edge) of the conductive surface of each glass piece, and 8 glass pieces were aligned in two lines without gap to make a 4 cm wide and 8 cm long strip with their adhesive tape-stuck edges making both sides (8 cm long) of the strip as spacers. The coating weight of the titanium dioxide particles was adjusted to 20 g/m². After coating, the adhesive tape was removed. The coating layer was air-dried at room temperature for 1 day and then calcined in an electric muffle furnace (Model FP-32, manufactured by Yamato Kagaku) at 450°C for 30 minutes. After being cooled out of the furnace, the coated glass substrate was immersed in a 3 × 10⁻⁴ mol/l ethanol solution of the dye shown in Table 2 below for 3 hours. The amount of the dye coated was selected appropriately from 0.1 to 10 mmol/m² according to the dye. The dyed glass substrates were immersed in 4-t-butylpyridine for 15 minutes, washed with ethanol, and dried spontaneously to obtain a dye-sensitized TiO₂ electrode substrate. The photosensitive layer (dye-sensitized TiO₂ layer) thus formed had a thickness of 10 µm.

### 3) Preparation of photo-electrochemical cell

As shown in Fig. 1, the dye-sensitized TiO₂ electrode substrate prepared above and a Pt-deposited glass substrate (counter electrode) of the same size (2 cm × 2 cm) were brought into contact with the TiO₂ electrode layer 3 and the Pt deposit layer 6 facing each other. An electrolyte prepared by mixing the electrolyte component in Table 2 and the solvent shown in Table 2 in a ratio shown and adding to the mixture 2 mol%, based on the electrolyte component, of iodine was penetrated into the sandwiched TiO₂ electrode by making use of capillarity to form an electrolyte layer. There were thus obtained photo-electrochemical cells 201 to 234 composed of a conductive glass substrate (glass 1 having a conductor layer 2), a TiO₂ electrode 3, a dye layer 4, an electrolyte layer 5, a Pt layer 6, and glass 7 in this order. Where the compound (I') used as an electrolyte component was solid at 25°C, it was incorporated into the electrode in a molten state obtained by heating or as dissolved in a low-boiling solvent, which was removed later, to form an electrolyte layer consisting solely of the compound (I').

### 4) Evaluation of photoelectric conversion efficiency:

The photoelectric characteristics of the photo-electrochemical cells prepared in Example 1 were evaluated as follows.

The conductive glass 1 and the Pt-deposited glass 7 were connected by means of alligator clips, and the cell was irradiated with pseudo-sunlight containing no ultraviolet rays having an intensity of 86 mW/cm² which was obtained by cutting light from a 500 W xenon lamp (produced by Ushio Inc.) through AM1.5 Filter (produced by Oriel) and a sharp cut filter (Kenko L-42). The generated electricity was measured with a current-voltmeter (Keithley Model SMU238) to obtain an open circuit voltage (V_{OC}), a short circuit current density (J_{SC}), a fill factor (FF) (=maximum output/(open circuit voltage × short circuit current)), and a conversion efficiency (η). After 480-hour continuous irradiation, the short circuit current density was again measured to obtain a rate of a reduction. The results obtained a rate of shown in Table 3 below.

### SYNTHESIS EXAMPLE 1

### Synthesis of F'-1

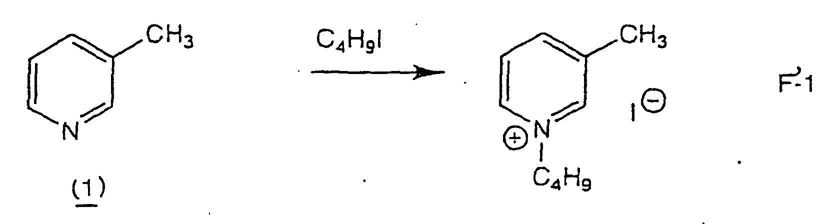

A mixture of 1.86 g (20 mmol) of 3-methylpyridine (1) and 7.36 g (40 mmol) of butane iodide was stirred at 100°C in a nitrogen atmosphere for 1 hour, followed by concentration under reduced pressure. The residue was purified by silica gel column chromatography (methylene chloride:methanol=5:1 by volume) to give 5.48 g (yield: 99%) of F'-1 as liquid. The structure of the product was confirmed by NMR analysis.

### SYNTHESIS EXAMPLE 2

### Synthesis of F'-3

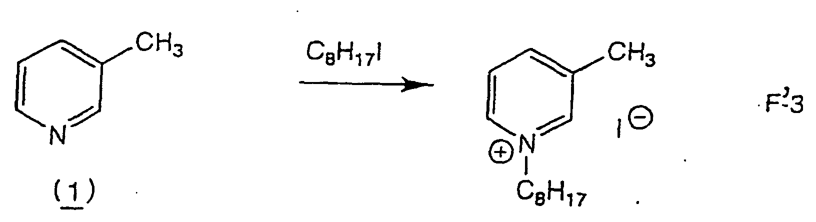

In the same manner as in Synthesis Example 4, except for replacing butane iodide with an equimolar amount of octane iodide, 6.59 g (yield: 99%) of F'-3 was obtained. The structure of the product was confirmed by NMR analysis.

### SYNTHESIS EXAMPLE 3

### Synthesis of F'-4

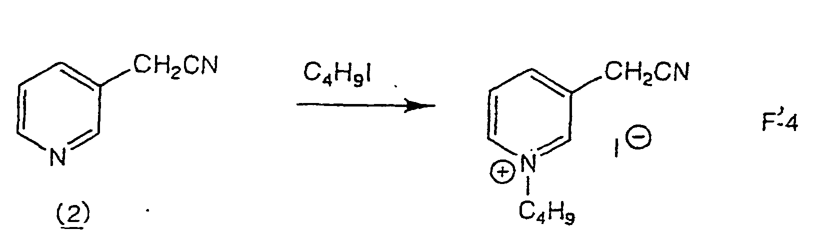

In the same manner as in Synthesis Example 4, except for replacing 3-methylpyridine with 2.36 g (20 mmol) of pyridine-3-acetonitrile (2), 5.86 g (yield: 97%) of F'-4 was obtained as liquid. The structure of the product was confirmed by NMR analysis.

### SYNTHESIS EXAMPLE 4

### Synthesis of F'-5

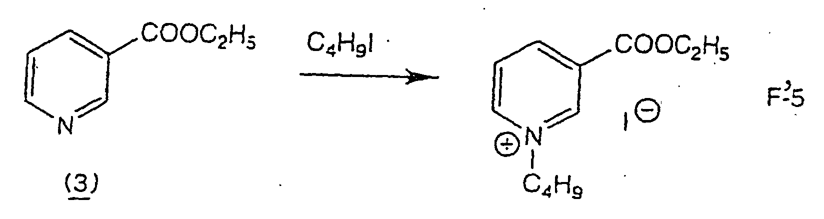

In the same manner as in Synthesis Example 4, except for replacing 3-methylpyridine with 3.02 g (20 mmol) of ethyl nicotinate (3), 6.10 g (yield: 91%) of F'-5 was obtained as liquid. The structure of the product was confirmed by NMR analysis.

### SYNTHESIS EXAMPLE 5

### Synthesis of F'-15

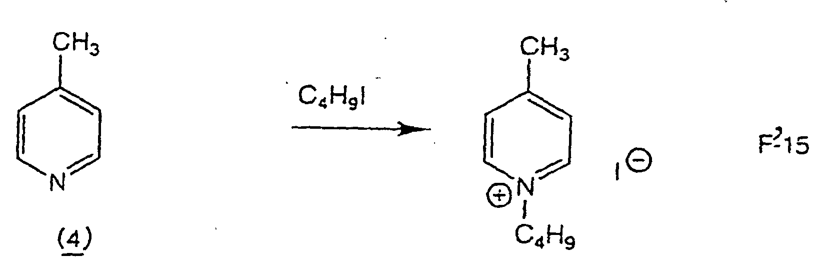

In the same manner as in Synthesis Example 4, except for replacing 3-methylpyridine with 1.86 g (20 mmol) of 4-methylpyridine (4), 5.48 g (yield: 99%) of F'-15 was obtained as liquid. The structure of the product was confirmed by NMR analysis.

Other compounds (I') having I⁻ were synthesized similarly to Synthesis Examples 4 to 8. Compounds (I') having I₃⁻ were synthesized by adding iodine (I₂) to the corresponding compounds (I') having the same cation and I⁻ as an anion in an amount of 1 to 10 mol, preferably 1 mol, per mole of the I⁻.

### 1) Preparation of titanium dioxide dispersion

The titanium dioxide dispersion was prepared in the same manner as in Example 1.

### 2) Preparation of dye-sensitized TiO₂ electrode

A dye-sensitized TiO₂ electrode was prepared in the same manner as in Example 1.

### 3) Preparation of photo-electrochemical cell

An electrolyte was prepared by mixing the electrolyte component shown in Table 2 and the solvent shown in Table 2 in a ratio shown and adding to the mixture 2 mol%, based on the electrolyte component, of iodine.

Photo-electrochemical cells 201 to 234 were prepared in the same manner as in Example 1.

### 4) Evaluation of photoelectric conversion efficiency

The photoelectric characteristics of the photo-electrochemical cells 201 to 234 were evaluated in the same manner as in Example 1. The results obtained are shown in Table 3 below.

**TABLE 2**

| Cell No. | Dye | Solvent (volume ratio) | Electrolyte Component | Content of Electrolyte Component (wt%) | Remark |
|---|---|---|---|---|---|
| 201 | R-1 | S-4/S-1=8/2 | LiI | 50 | Comparison |
| 202 | R-1 | S-4/S-1=8/2 | (C₄H₉)₄NI | 15 | " |
| 203 | R-1 | S-4/S-1=8/2 | (C₄H₉)₄NI | 50 | " |
| 204 | R-1 | S-4/5-1=8/2 | F'-1 | 50 | Invention |
| 205 | R-1 | S-4/S-1=8/2 | F'-1 | 70 | " |
| 206 | R-1 | S-4/S-1=8/2 | F'-1 | 80 | " |
| 207 | R-1 | - | F'-1 | 100 | " |
| 208 | R-1 | S-6 | F'-1 | 50 | " |
| 209 | R-1 | S-6 | F'-1 | 80 | " |
| 210 | R-1 | S-5 | F'-1 | 50 | " |
| 211 | R-1 | - | F'-3 | 100 | " |
| 212 | R-1 | - | F'-4 | 100 | " |
| 213 | R-1 | - | F'-5 | 100 | " |
| 214 | R-1 | - | F'-6 | 100 | " |
| 215 | R-1 | - | F'-15 | 100 | " |
| 216 | R-13 | - | F'-1 | 100 | " |
| 217 | (1) | - | F'-9 | 100 | " |
| 218 | (3) | - | F'-13 | 100 | " |
| 219 | (5) | S-6 | F'-16 | 80 | " |
| 220 | (5) | - | F'-1 | 100 | " |
| 221 | (26) | - | F'-15 | 100 | " |
| 222 | (26) | S-6 | F'-33 | 80 | " |
| 223 | (29) | - | F'-15 | 100 | " |
| 224 | (29) | S-6 | F'-36 | 80 | " |
| 225 | (32) | - | F'-1 | 100 | " |
| 226 | (37) | - | F'-1 | 100 | " |
| 227 | (37) | - | F'-15 | 100 | " |
| 228 | (37) | S-6 | F'-6 | 90 | " |
| 229 | (37) | S-6 | F'-4 | 90 | " |
| 230 | (37) | S-6 | F'-5 | 80 | " |
| 231 | (37) | - | F'-1 | 100 | " |
| 232 | (43) | S-5 | F'-15 | 80 | " |
| 233 | R-1 | S-4/S-1=8/2 | MHIm | 50 | Comparison |
| 234 | R-1 | - | MHIm | 100 | " |
| Note: MHIm: iodine salt of 1-methyl-3-hexylimidazolium (WO95/18456) | | | | | |

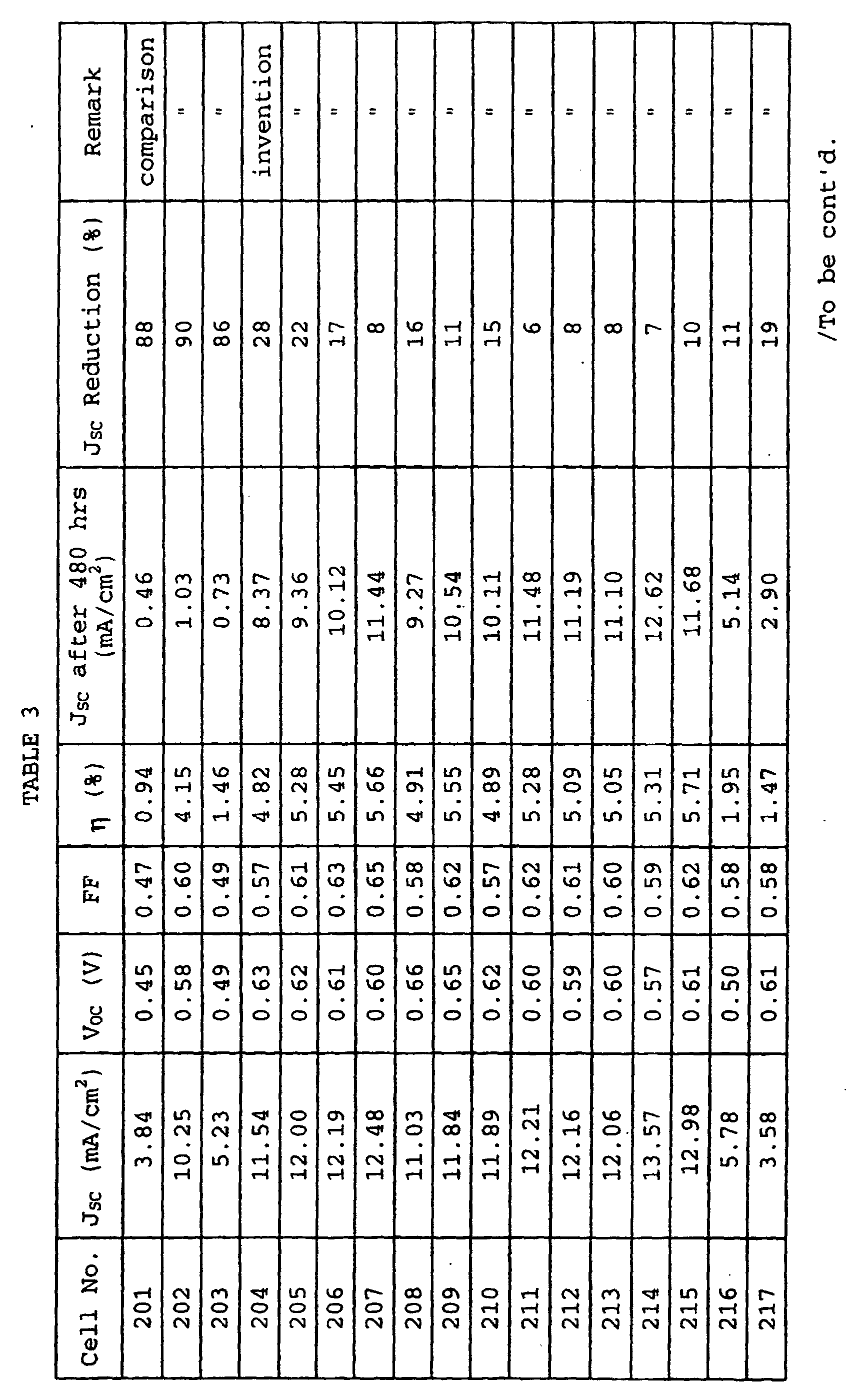

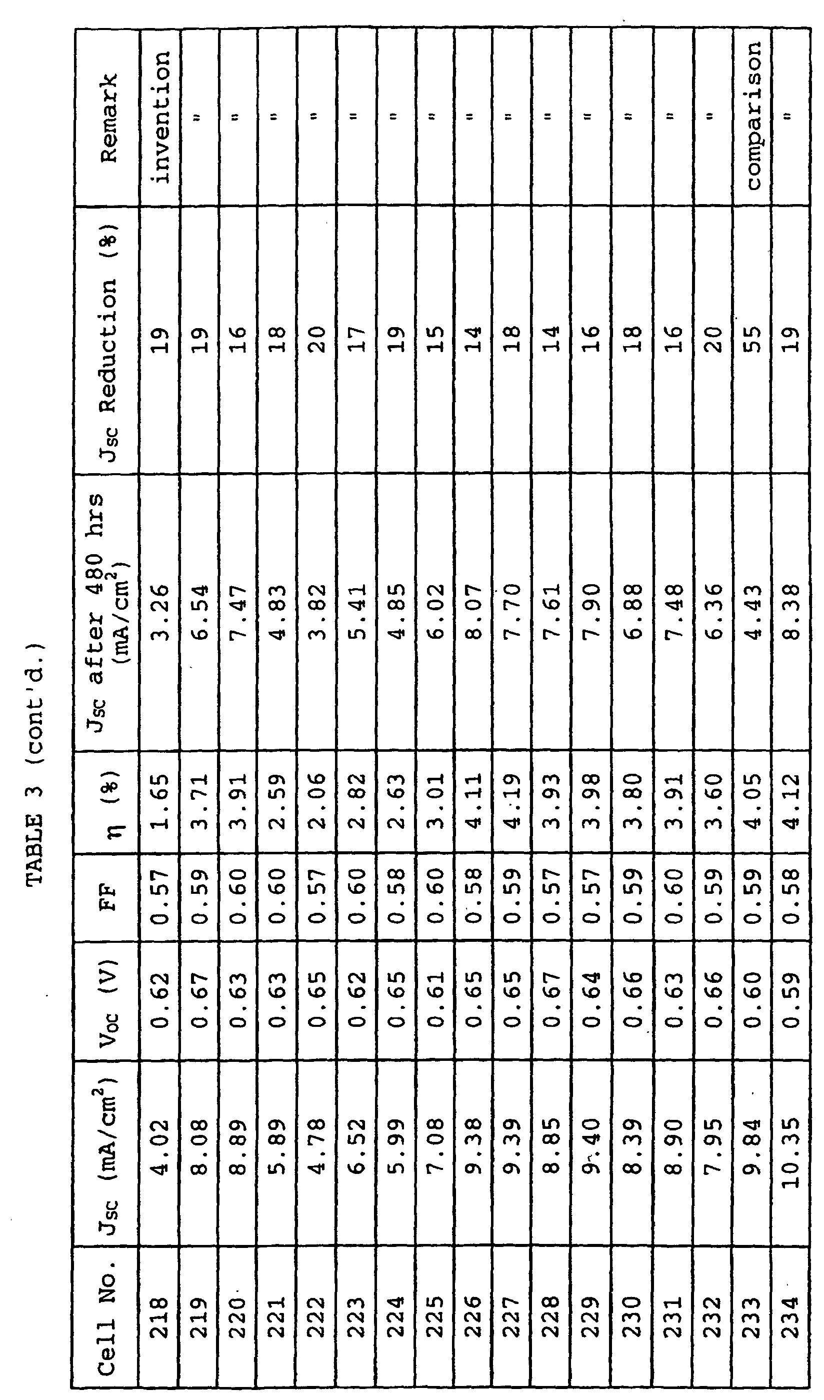

As is apparent from the results of Tables 2 and 3, the photo-electrochemical cells of the invention in which the electrolyte comprises 50 wt% of the compound (I'), which has good compatibility with the solvent, exhibit excellent initial performance in short circuit current density, photoelectric conversion efficiency, etc. as well as excellent durability of the performance, whereas those in which the electrolyte comprises 50 wt% of the comparative electrolyte component, such as LiI and (C₄H₉)₄NI, are considerably inferior in both initial performance and durability on account of the poor solubility of the electrolyte component. Both the initial performance and durability are further improved with an increase of the proportion of the compound (I') in the electrolyte. These effects of the compound (I') are observed irrespective of the kind of the dye. It is also seen that the photo-electrochemical cells of the invention in which the electrolyte comprises 50 wt% or more of the compound (I') are superior particularly in durability owing to the volatility resistance as compared with those using an ordinary electrolyte having a greater solvent content (the salt content is 15 wt% or less). On the other hand, MHIm (iodine salt of 1-methyl-3-hexylimidazolium), which is a well-known electrolyte compound, is inferior to the compound (I') in short circuit current density and photoelectric conversion efficiency particularly where used in a high proportion.

Additionally, the results prove that high-boiling solvents, such as S-5 and S-6, are preferred solvents to be used in combination with the compound (I') in terms of durability.

## Claims

1. A photo-electrochemical cell comprising a semiconductor responsive to a radiant ray, a charge transporting layer, and an counter electrode, wherein said charge transporting layer comprises an electrolyte containing a compound represented by formula (I'): 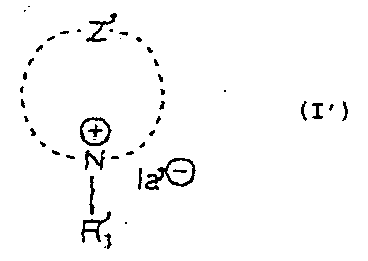 wherein Z' represents an atomic group necessary to form a 6-membered aromatic ring cation together with the nitrogen atom; R1' represents an alkyl group or an alkenyl group; and a' represents 1 or 3.

2. The photo-electrochemical cell according to claim 1, wherein said compound represented by formula (I') is a pyridinium compound represented by formula (II'): 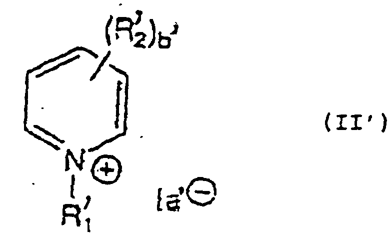 wherein R1' represents an alkyl group or an alkenyl group; R2' represents a substituent; a' represents 1 or 3; b' represents an integer of 0 to 5; when b' is 2 or greater, (R2')'s may be the same or different.

3. The photo-electrochemical cell as in claim 2, wherein said pyridinium compound is a compound represented by formula (III'): 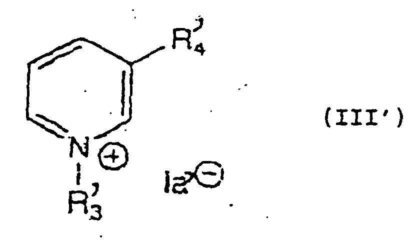 wherein R3' represents an unsubstituted alkyl group having 4 to 10 carbon atoms; R4' represents an unsubstituted or cyano-substituted alkyl group or an alkoxycarbonyl group; and a' represents 1 or 3.

4. The photo-electrochemical cell as in claim 1, wherein electrolyte containing said compound represented by formula (I') is present in an amount of 50% by weight or more based on the electrolyte.

5. The photo-electrochemical cell as in claim 1, wherein said semiconductor is a dye-sensitized particulate semiconductor.

6. A pyridinium compound represented by formula (IV'): 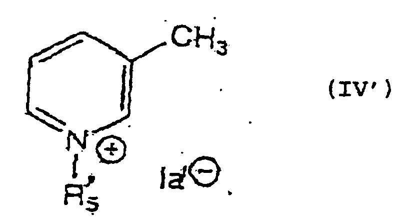 wherein R5' represents an unsubstituted straight-chain alkyl group having 4 to 8 carbon atoms; and a' represents 1 or 3.

## Patentansprüche

1. Photoelektrochemische Zelle aufweisend einen Halbleiter, der auf Strahlung reagiert, eine Ladungstransportschicht, und eine Gegenelektrode, wobei die Ladungstransportschicht einen Elektrolyten umfaßt, der eine Verbindung enthält, die durch folgende Formel (I') dargestellt ist: 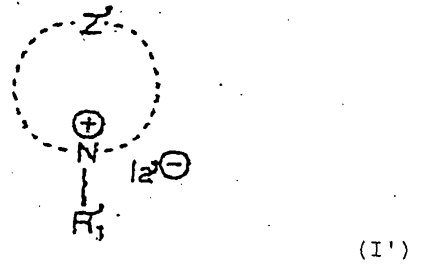 wobei Z' eine Atomgruppe darstellt, die erforderlich ist, ein sechsgliedriges aromatisches Ringkation gemeinsam mit dem Stickstoffatom zu bilden; wobei R1' eine Alkylgruppe oder eine Alkenylgruppe darstellt; und wobei a' für 1 oder 3 steht.

2. Photoelektrochemische Zelle nach Anspruch 1, wobei die Verbindung, welche durch die Formel (I') dargestellt ist, eine Pyridiumverbindung ist, die durch die Formel (II') dargestellt ist: 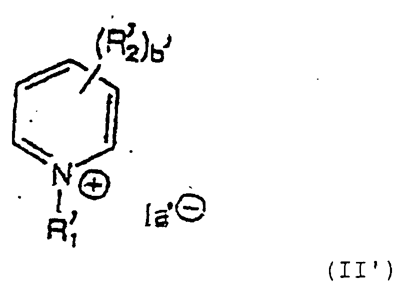 wobei R1' eine Alkylgruppe oder eine Alkenylgruppe darstellt; wobei R2' einen Substituenten darstellt; wobei a' für 1 oder 3 steht; wobei b' eine ganze Zahl von 0 bis 5 darstellt; wobei b' 2 oder größer ist, wobei die (R2') dieselben oder unterschiedlich sind.

3. Photoelektrochemische Zelle nach Anspruch 2, wobei die Pyridiumverbindung eine durch die Formel (III') dargestellte Verbindung ist: 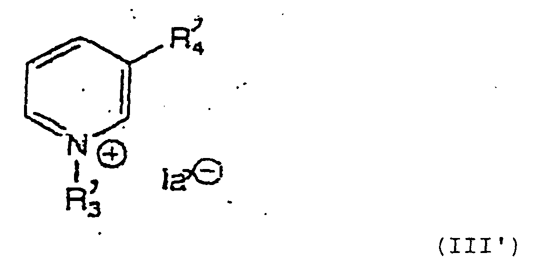 wobei R3' eine unsubstituierte Alylgruppe mit 4 bis 10 Kohlenstoffatomen darstellt; wobei R4' eine unsubstituierte oder cyanosubstituierte Alkylgruppe oder eine Alkoxycarbonylgruppe darstellt; und wobei a' für 1 oder 3 steht.

4. Photoelektrochemische Zelle nach Anspruch 1, wobei ein Elektrolyt, der die Verbindung enthalt, die durch die Formel (I') dargestellt ist, in einer Gewichtsmenge von 50 % oder einer größeren Menge basierend auf dem Elektrolyten vorliegt.

5. Photoelektrochemische Zelle nach Anspruch 1, wobei es sich bei dem Halbleiter um einen farbstoffsensibilisierten, aus Partikeln bestehenden Halbleiter handelt.

6. Pyridinverbindung, dargestellt durch die Formel (IV') 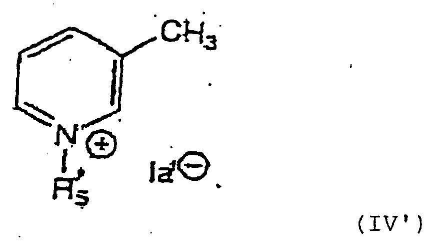 wobei R5' eine unsubstituierte geradkettige Alkylgruppe mit 4 bis 8 Kohlenstoffatomen darstellt; und wobei a' für 1 oder 3 steht.

## Revendications

1. Cellule photoélectrochimique, comprenant un semi-conducteur répondant à un rayonnement radiant, une couche de transport de charge et une contre-électrode, dans laquelle ladite couche de transport de charge comprend un électrolyte contenant un composé représenté par la formule (I') : 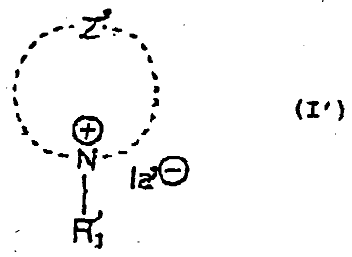 dans laquelle Z' représente un groupe atomique nécessaire pour former un cation de cycle aromatique à 6 membres ainsi que l'atome d'azote ; R'₁ représente un groupe alkyle ou un groupe alcényle ; et a' représente 1 ou 3.

2. Cellule photo-électrochimique selon la revendication 1, dans laquelle ledit composé représenté par la formule (I') est un composé de pyridinium représenté par la formule (II') : 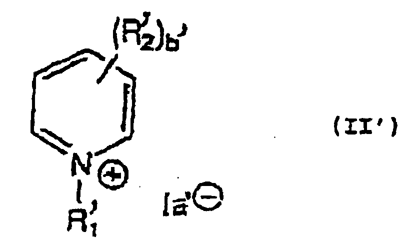 dans laquelle R'₁ représente un groupe alkyle ou un groupe alcényle ; R'₂ représente un substituant ; a' représente 1 ou 3 ; b' représente un entier de 0 à 5 ; quand b' est égal à 2 ou plus, les (R'₂) peuvent être identiques ou différents.

3. Cellule photoélectrochimique selon la revendication 2, dans laquelle ledit composé de pyridinium est un composé représenté par la formule (III') : 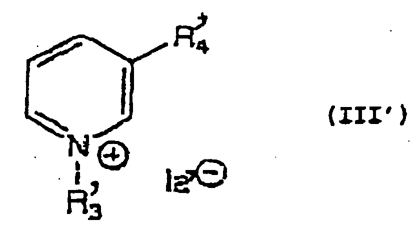 dans laquelle R'₃ représente un groupe alkyle non substitué ayant de 4 à 10 atomes de carbone ; R'₄ représente un groupe alkyle substitué par un cyano ou non substitué ou un groupe alcoxycarbonyle ; et a' représente 1 ou 3.

4. Cellule photoélectrochimique selon la revendication 1, dans laquelle l'électrolyte contenant ledit composé représenté par la formule (I') est présent en une quantité de 50 % en poids ou plus sur la base de l'électrolyte.

5. Cellule photoélectrochimique selon la revendication 1, dans laquelle ledit semi-conducteur est un semi-conducteur particulaire sensibilisé aux colorants.

6. Composé de pyridinium représenté par la formule (IV') : 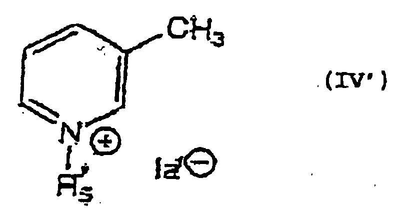 dans laquelle R'₅ représente un groupe alkyle non substitué à chaîne linéaire ayant de 4 à 8 atomes de carbone ; et a' représente 1 ou 3.
